(19) Europäisches Patentamt
European Patent Office
Office européen des brevets

(11) Veröffentlichungsnummer: **0 162 017 B1**

(12) **EUROPÄISCHE PATENTSCHRIFT**

(45) Veröffentlichungstag der Patentschrift: **21.08.91**

(51) Int. Cl.5: **C08G 73/10**, G03F 7/004, G03C 11/08, G03F 7/26

(21) Anmeldenummer: **85810222.1**

(22) Anmeldetag: **09.05.85**

Die Akte enthält technische Angaben, die nach dem Eingang der Anmeldung eingereicht wurden und die nicht in dieser Patentschrift enthalten sind.

# (54) Homo- und Copolymere, Verfahren zu deren Vernetzung und derenVerwendung.

(30) Priorität: **17.05.84 CH 2417/84**

(43) Veröffentlichungstag der Anmeldung:
**21.11.85 Patentblatt 85/47**

(45) Bekanntmachung des Hinweises auf die Patenterteilung:
**21.08.91 Patentblatt 91/34**

(84) Benannte Vertragsstaaten:
**BE CH DE FR GB IT LI NL SE**

(56) Entgegenhaltungen:
**EP-A- 0 027 506**
**EP-A- 0 092 524**
**DE-B- 1 764 977**
**FR-A- 1 565 700**
**GB-A- 1 222 630**

(73) Patentinhaber: **CIBA-GEIGY AG**
**Klybeckstrasse 141**
**CH-4002 Basel(CH)**

(72) Erfinder: **Pfeifer, Josef, Dr.**
**Brunnmattstrasse 32**
**CH-4106 Therwil(CH)**

EP 0 162 017 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft Homo- und Copolymere, die Benzoylpyromellitsäureimideinheiten und/oder Imideinheiten von aromatischen Tetracarbonsäuren, bei denen die Imidgruppen tragenden aromatischen Reste über Carbonylgruppen an aromatische Reste gebunden sind, enthalten, ein mit diesen Polymeren beschichtetes Material und die Verwendung des beschichteten Materials zur Herstellung von Schutzfilmen oder photographischen Reliefabbildungen durch Bestrahlung.

Photographische Abbildungsverfahren mit strahlungsempfindlichen Polymeren zur Erzeugung von Reliefabbildungen haben zur Herstellung von Bauteilen in der Elektronik und Halbleitertechnologie grosse Bedeutung erlangt. Von solchen Photopolymeren werden je nach Verwendungszweck bestimmte Eigenschaften verlangt und es sind hierfür verschiedenartige Polymere bekannt geworden. Die Lichtempfindlichkeit solcher Polymerer ist relativ gering, was den Zusatz von Photoinitiatoren oder Sensibilisatoren erfordert, um wirtschaftliche Belichtungszeiten zu erzielen. Nachteilig bei solchen Additiven ist, dass sie die mechanischen und physikalischen Eigenschaften vermindern können.

Für bestimmte Anwendungen sind ferner hohe Temperaturbeständigkeiten der erzeugten Strukturen oder photochemisch hergestellter Schutzüberzüge gewünscht. Besonders geeignet hierfür sind Polyimide. Wegen ihrer Unlöslichkeit muss man von löslichen Vorstufen ausgehen, die erst nach der Photopolymerisation durch eine thermische Nachbehandlung in Polyimide überführt werden. Eine direkte Photovernetzung von Polyimiden ist bisher nicht bekannt geworden.

Aus der GB-PS 1 222 630 sind Polyimide mit Benzoyl- oder Naphtoylpyromellitsäure bekannt. In der FR-PS 1 601 094 und der FR-PS 1 565 700 sind Polyimide von aromatischen Tetracarbonsäuren beschrieben, deren aromatischen, die Carboxylgruppen tragenden Kerne über Carbonylgruppen an weitere aromatische Kerne gebunden sind. Aromatische Polyimide, die in beiden Orthostellungen zu mindestens einem N-Atom substituiert sind, sind nicht erwähnt. Den Publikationen kann auch nicht entnommen werden, dass die Polyimide strahlungsempfindlich sind.

Es wurde nun gefunden, dass Polymere mit den beschriebenen Imideinheiten autophotovernetzbar sind.

Ein Gegenstand vorliegender Erfindung ist somit ein Verfahren zur Herstellung vernetzter Polymerer, dadurch gekennzeichnet, dass man ein Homo- oder Copolymeres, das ein mittleres Molekulargewicht von mindestens 2000 aufweist und das mindestens 5 Mol%, bezogen auf das Polymer, mindestens eines Strukturelementes der Formel I und/oder II enthält

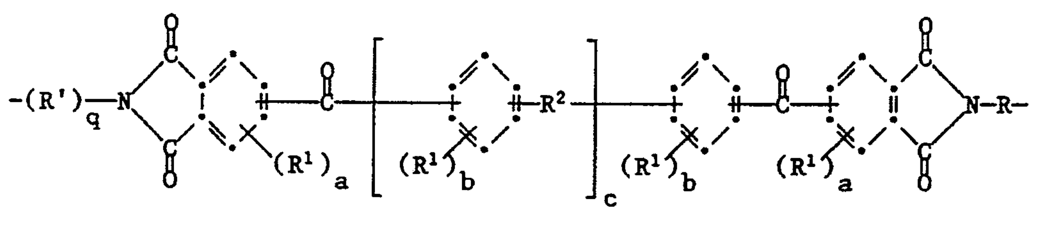

(I)

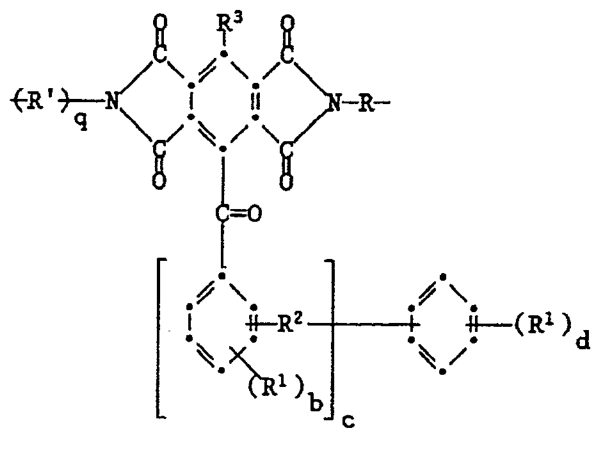

(II),

worin

$R^1$ für Halogen, Nitro, $C_1$-$C_6$-Alkyl, $C_1$-$C_6$-Alkoxy, $C_1$-$C_6$-Alkylthio, das durch Phenyl substituiert sein kann, Phenyl, Phenoxy oder Phenylthio steht,

$R^2$ eine direkte Bindung oder eine Brückengruppe bedeutet
$R^3$ für ein Wasserstoffatom oder Aryl steht oder die gleiche Bedeutung wie $R^1$ hat,
a für 0, 1, 2 oder 3, b für 0, 1, 2, 3 oder 4, c und d für 0, 1, 2, 3, 4 oder 5 stehen, q für 0 oder 1 steht, und falls
a, b und d 2 sind, auch beide $R^1$ in o-Stellung gebunden sein und zusammen -CH=CH-CH=CH- bedeuten können, und
R und R' ein unsubstituierter oder substituierter zweiwertiger aliphatischer Rest, der durch Heteroatome, aromatische, heterocyclische oder cycloaliphatische Gruppen unterbrochen sein kann, ein unsubstituierter oder substituierter cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxygruppe, Alkoxyalkylgruppe, Alkylthiogruppe, Alkylthioalkylgruppe oder Aralkylgruppe substituierter aromatischer Rest oder an zwei benachbarten C-Atomen des aromatischen Restes durch eine Alkylengruppe substituierter aromatischer Rest sind, wobei R ein aromatischer Rest ist, der in beiden Orthostellungen mindestens eines N-Atoms substituiert ist, wenn q = 0 ist, mit energiereicher Strahlung bestrahlt.

Ein weiterer Gegenstand vorliegender Erfindung ist ein Homo- oder Copolyimid mit einem mittleren Molekulargewicht von mindestens 2000, das mindestens 5 Mol%, bezogen auf das Polyimid, mindestens eines Strukturelementes der Formeln Ib oder IIb enthält

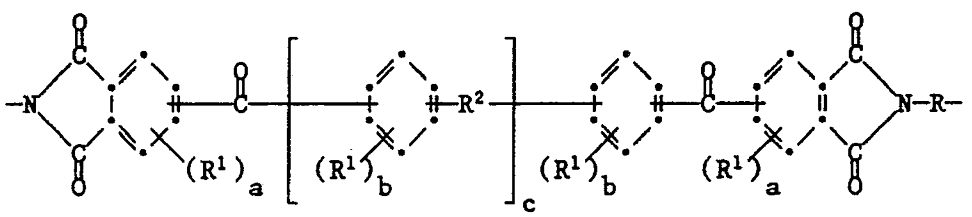

(Ib),

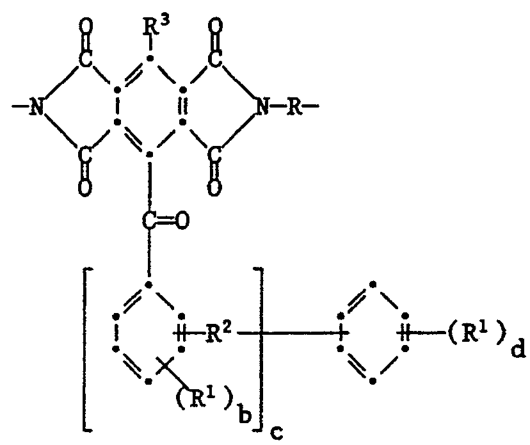

(IIb),

worin $R^1$, $R^2$, $R^3$, a, b, c und d die oben angegebene definierte Bedeutung besitzen und R ein aromatischer Rest ist, der in beiden Orthostellungen mindestens eines N-Atoms durch Alkyl, Cycloalkyl, Alkoxy, Alkoxyalkyl, Alkylthio, Alkylthioalkyl oder Aralkyl substituiert ist oder worin zwei benachbarte C-Atome des aromatischen Restes durch Alkylen substituiert sind.

Die vorliegende Erfindung betrifft auch ein Copolymer mit einem mittleren Molekulargewicht von mindestens 2000, das ausgewählt ist aus der Gruppe der Polyamide, gesättigten Polyester, Polycarbonate, Polyamidimide, Polyesterimide, Polyesteramide, Polysiloxane, ungesättigten Polyester, Epoxidharze, der aromatischen Polyäther, der aromatischen Polyätherketone, der aromatischen Polyäthersulfone, der aromatischen Polyketone, der aromatischen Polythioäther oder Gemischen dieser Polymeren, dadurch gekennzeichnet, dass das Copolymer mindestens 5 Mol %, bezogen auf das Copolymer, mindestens eines Strukturelementes der Formeln I oder II enthält, worin q = 1 ist.

Bei Homo- oder Copolyimiden und den Copolymeren mit Strukturelementen der Formel I und/oder II, worin R und R' einen aliphatischen oder cycloaliphatischen Rest bedeuten, beträgt die Menge dieser

Strukturelemente bevorzugt mindestens 50 Mol-%, besonders wenn es sich bei den Homo- und Copolymeren um Polyamide und Polyester handelt.

$R^1$ ist als Halogen bevorzugt F oder Cl. Beispiele für $R^1$ als Alkyl, Alkoxy und Alkylthio sind Methyl, Ethyl, Propyl, i-Propyl, Butyl, Pentyl, Hexyl, Methoxy, Aethoxy, Propoxy, Methylthio, Ethylthio und Benzylthio.

In den Formeln I und II stehen a, b und d bevorzugt für 1 und besonders für 0 und c steht bevorzugt für 1 oder 2 und besonders für 0.

Bei der Brückengruppe $R^2$ kann es sich zum Beispiel um Reste wie -O-, -S-, -SO-, $-SO_2-$, -CO-, $-NR^a-$, lineares oder verzweigtes $C_1$-$C_{10}$-Alkylen, das mit F oder Cl substituiert sein kann, $-CO_2-$, $-CONR^a$-$C_2$-$C_6$-Alkyliden,

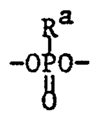, 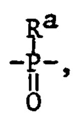,

das durch F oder Cl substituiert sein kann, Cycloalkyliden mit 5 oder 6 Ringkohlenstoffatomen,

$$-(O-C_mH_{2m})_n-O-$$

mit m = 2 bis 4 und n gleich 1 bis 4,

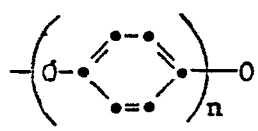

mit n gleich 1 bis 4 handeln. $R^a$ kann $C_1$-$C_6$-Alkyl, Phenyl, Benzyl oder Cyclohexyl sein.

Weitere Brückengruppen sind zum Beispiel -N=N-,

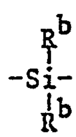 und 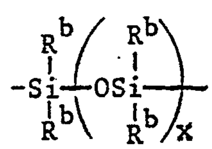 ,

worin $R^b$ $C_1$-$C_6$-Alkyl, besonders Methyl, oder Phenyl oder Benzyl ist und x für eine rationale Zahl von 1 bis 10 steht.

Bevorzugt ist $R^2$ eine direkte Bindung, -O-, -S-, $CH_2$, Aethyliden, 2,2-Propyliden und besonders -CO-.

$R^3$ ist als Aroyl besonders Benzoyl. Bevorzugt ist $R^3$ ein Wasserstoffatom.

Die Carbonylgruppen in Formel I befinden sich bevorzugt in Metastellung zu den Carbonylgruppen der Imidgruppe. Wenn c = 0 ist, befinden sich auch die Carbonylgruppen zueinander bevorzugt in Metastellung. Die $R^2$ -Gruppe kann sich in Parastellung, bevorzugter in Metastellung zu den Carbonylgruppen befinden.

Bevorzugte Strukturelemente entsprechen den Formeln Ia und IIa

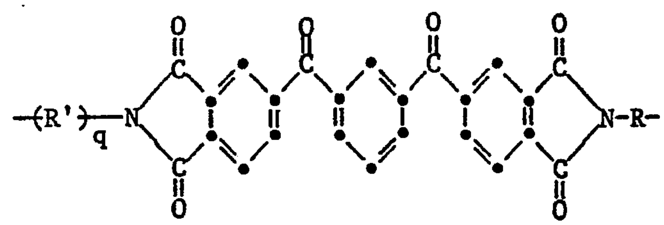

(Ia)

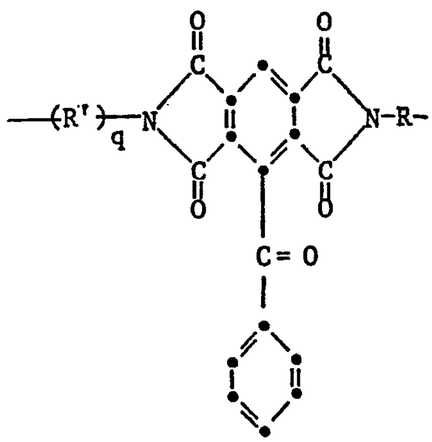

(IIa),

worin q, R und R' die in Anspruch 1 angegebene Bedeutung haben.

R bzw. R' in den Formeln I und II in der Bedeutung als zweiwertiger aliphatischer Rest enthält bevorzugt 2 bis 30, besonders 6 bis 30 und insbesondere 6 bis 20 C-Atome. In einer bevorzugten Untergruppe ist R bzw. R' lineares oder verzweigtes Alkylen, das durch Sauerstoffatome, S, SO, $SO_2$, NH, $^{c\oplus}NR_2{}^{c}G^{\ominus}$, Cyclohexylen, Naphthylen, Phenylen oder Hydantoinreste unterbrochen sein kann. $R^c$ kann z.B. Alkyl mit 1 bis 12 C-Atomen oder Cycloalkyl mit 5 oder 6 Ring-C-Atomen, Phenyl oder Benzyl sein. $G^{\ominus}$bedeutet ein Anion einer Protonensäure, z.B. Halogenid, Sulfat, Phosphat. In einer bevorzugten Ausführungsform sind R bzw. R' lineares oder verzweigtes Alkylen mit 6 bis 30 C-Atomen, $-(CH_2)_m-R^4-(CH_2)_n-$, worin $R^4$ Phenylen, Naphthylen, Cyclopentylen oder Cyclohexylen und m und n unabhängig voneinander die Zahl 1, 2 oder 3 sind,

$$-R^5-(OR^6)_p-O-R^5-,$$

worin $R^5$ Aethylen, 1,2-Propylen, 1,3-Propylen oder 2-Methyl-1,3-propylen und $R^6$ Aethylen, 1,2-Propylen, 1,2-Butylen, 1,3-Propylen oder 1,4-Butylen und p eine Zahl von 1 bis 100 sind, oder

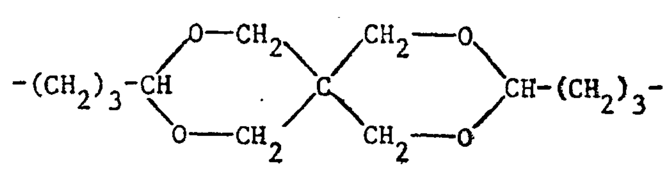

.

Beispiele für aliphatische Reste sind: Methylen, Aethylen, 1,2-oder 1,3-Propylen, 2,2-Dimethyl-1,3-propylen, 1,2-, 1,3- oder 1,4-Butylen, 1,3- oder 1,5-Pentylen, Hexylene, Heptylene, Octylene, Decylene, Dodecylene, Tetradecylene, Hexadecylene, Octadecylene, Eicosylene, 2,4,4-Trimethylhelen, 1,10-Dialkyldecylen, wobei das Alkyl bevorzugt 1- bis 6 C-Atome aufweist, substituierte 1,11-Undecylene, wie sie z.B. in der EP-B-0 011 559 beschrieben sind, Jeffamine wie z.B.

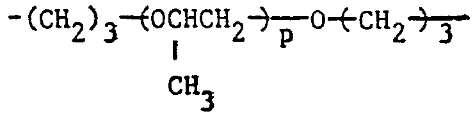

mit p = 1 bis 100 oder

$$-(CH_2)_3-(O(CH_2)_4)_p-O-(CH_2)_3-$$

mit p = 1-100, Dimethylencyclohexan, Xylylen und Diäthylenbenzol. Besonders bevorzugt sind R bzw. R' längerkettiges, verzweigtes Alkylen mit z.B. 8 bis 30 C-Atomen.

R bzw. R' in den Formeln I und II kann als aliphatischer Rest auch einen Polysiloxanrest der Formel

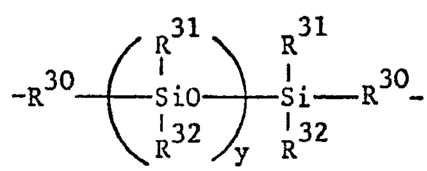

bedeuten, worin $R^{31}$ und $R^{32}$ $C_1$-$C_6$-Alkyl, besonders Methyl, oder Phenyl sind, $R^{30}$ Cycloalkylen wie z.B. Cyclohexylen und besonders $C_1$-$C_{12}$, insbesondere $C_1$-$C_6$-Alkylen, z.B. 1,3-Propylen oder 1,4-Butylen, ist und y für eine rationale Zahl von mindestens 1, z.B. 1 bis 100, bevorzugt 1 bis 10 steht. Solche Diamine mit diesem Rest sind in der US-PS 3 435 002 und US-PS 4 030 948 beschrieben.

Bei den durch heterocyclische Reste unterbrochenen aliphatischen Resten kann es sich z.B. um solche handeln, die sich von N,N'-aminoalkylierten Hydantoinen oder Benzimidazolen ableiten. Beispiele sind N,N'-(γ-Aminopropyl)-5,5-dimethyl-hydantoin oder -benzimidazolon und solche der Formel

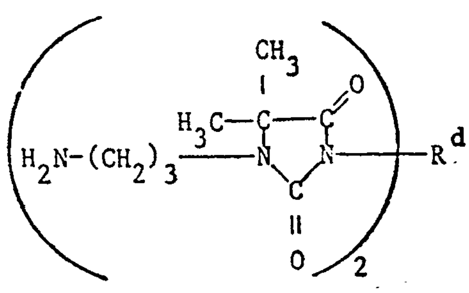

,

worin $R^d$ Alkylen mit 1 bis 12, bevorzugt 1 bis 4 C-Atomen oder

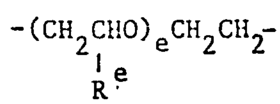 ist,

worin $R^e$ ein Wasserstoffatom oder Methyl und e ganze Zahlen von 1-20 bedeuten.

Geeignete Substituenten für die aliphatischen Reste sind z.B. Hydroxyl, Halogenid wie F oder Cl oder Alkoxy mit 1 bis 6 C-Atomen.

Heterocyclische Diaminreste leiten sich bevorzugt von N-heterocyclischen Diaminen ab, z.B. von Pyrrolidin, Indol, Piperidin, Pyridin, Pyrrol, deren N-Atom alkyliert, z.B. methyliert, sein kann. Ein Beispiel ist N-Methyl-4-amino-5-aminoethylpiperidin.

R bzw. R' in den Formeln I und II in ihrer Bedeutung als zweiwertiger cycloaliphatischer Rest enthalten bevorzugt 5 bis 8 Ring-C-Atome und sind besonders unsubstituiertes oder mit Alkyl, das vorzugsweise 1 bis 4 C-Atome enthält, substituiertes ein- oder zweikerniges Cycloalkylen mit 5 bis 7 Ring-C-Atomen in

einem Ring. In einer bevorzugten Ausführungsform sind R bzw. R' als cycloaliphatischer Rest solche der Formeln

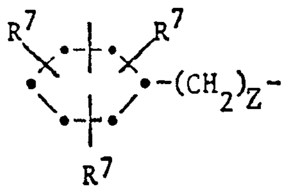 oder 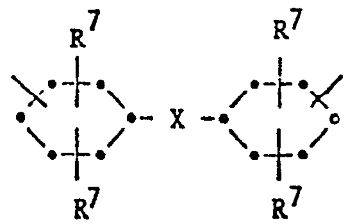 ,

worin Z 0 oder 1 ist, die $R^7$ unabhängig Wasserstoff oder Alkyl mit 1 bis 6 C-Atomen bedeuten und X für eine direkte Bindung, O, S, $SO_2$, Alkylen mit 1 bis 3 C-Atomen oder Alkyliden mit 2 bis 6 C-Atomen steht. $R^7$ ist bevorzugt ein Wasserstoffatom, Aethyl und Methyl, X bevorzugt Methylen und das Alkyliden enthält bevorzugt 2 oder 3 C-Atome, wie Aethyliden und 1,1- oder 2,2-Propyliden.

Beispiele für R bzw. R' als Cycloalkylen sind: 1,2- oder 1,3-Cyclopentylen, 1,2-, 1,3- oder 1,4-Cyclohexylen, Cycloheptylen, Cyclooctylen, Methylcyclopentylen, Methyl- oder Dimethylcyclohexylen, 5-Methyl-3-methylencyclohex-1-yl, 3,3'- oder 4,4'-Bis-cyclohexylen, 3,3'-Dimethyl-4,4'-biscyclohexylen, 4,4'-Biscyclohexlenäther oder -sulfon oder -methan oder -2,2-propan, sowie die Reste von Bis-aminomethyltricyclodecan, Bis-aminomethylnorbornan und Menthandiamin.

Besonders bevorzugt sind R bzw. R' als cycloaliphatischer Rest 1,4- oder 1,3-Cyclohexylen, 2,2,6-Trimethyl-6-methylen-cyclohex-4-y1, Methylenbis(cyclohex-4-yl) oder Methylenbis(3-methylcyclohex-4-yl).

R bzw. R' als araliphatischer Rest enthalten bevorzugt 7 bis 30 C-Atome. Sofern die aromatische Gruppe des araliphatischen Restes an die N-Atome im Rest der Formeln I und II gebunden sind, was bevorzugt ist, so sind diese aromatischen Gruppen bevorzugt so substituiert wie R bzw. R' als aromatischer Rest, einschliesslich der Bevorzugungen.

Der araliphatische Rest enthält bevorzugt 7 bis 30, besonders 8 bis 22 C-Atome. Der aromatische Rest im araliphatischen Rest ist bevorzugt ein Phenylrest. In ihrer Bedeutung als araliphatischer Rest bedeuten R bzw. R' besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

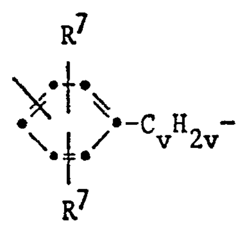

worin die $R^7$ unabhängig voneinander ein Wasserstoffatom oder besonders Alkyl mit 1-6 C-Atomen und v ganze Zahlen von 1-20 bedeuten.

Die freie Bindung kann sich in o-Stellung, m-Stellung und besonders in p-Stellung zur $C_vH_{2v}$-Gruppe befinden und eine oder beide $R^7$ sind bevorzugt in o-Stellung zur freien Bindung gebunden.

Beispiele für R bzw. R' als araliphatischer Rest sind: m- oder p-Benzylen, 3-Methyl-p-benzylen, 3-Aethyl-p-benzylen, 3,5-Dimethyl-p-benzylen, 3,5-Diäthyl-p-benzylen, 3-Methyl-5-äthyl-p-benzylen, p-Phenylenpropylen, 3-Methyl-p-phenylen-propylen, p-Phenylenbutylen, 3-Aethyl-p-phenylenpentylen sowie insbesondere längerkettige Phenylenalkylenreste, die z.B. in der EP-A-0 069 062 beschrieben sind: 6- (p-Phenylen)-6-methylhept-2-yl, 6-(3'-Methyl-p-phenylen)-6-methylhept-2-yl, 6-(3'-Aethyl-p-phenylen)-6-methylhept-2-yl, 6-(3',5'-Dimethyl-p-phenylen)-6-methylhept-2-yl, 11-(p-Phenylen)-2,11-dimethyl-dodec-1-yl, 13-(p-Phenylen)-2,12-dimethyltetradec-3-yl.

R bzw. R' können auch ein aromatischer Rest mit bevorzugt 13 bis 30 C-Atomen sein, bei dem zwei Arylkerne, zum Beispiel Naphthyl und besonders Phenyl über eine aliphatische Gruppe mit bevorzugt 1 bis 12 C-Atomen verknüpft sind.

Dieser Rest entspricht besonders der Formel

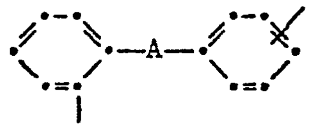

worin die freie Bindung in p-, m- und besonders o-Stellung zur A-Gruppe gebunden ist und A $C_1$-$C_{12}$-, besonders $C_1$-$C_6$-Alkylen ist, das durch O oder S unterbrochen sein kann. Beispiele für A sind Aethylen, 1,2- oder 1,3-Propylen, Butylen, $-CH_2-O-CH_2-$, $-CH_2-S-CH_2-$und $-CH_2CH_2-O-CH_2CH_2-$.

Unter den Homo- und Copolymeren sind besonders solche mit Strukturelementen der Formeln I und II bevorzugt, in der R bzw. R' substituierte aromatische Reste bedeuten. Der Substituent am aromatischen Rest enthält bevorzugt 1 bis 20, besonders 1-12 und insbesondere 1-6 C-Atome. Insbesondere ist der Substituent $C_5$- oder $C_6$-Cycloalkyl, lineares oder verzweigtes Alkyl, Alkoxy, Alkoxyalkyl, Alkylthio, Alkylthioalkyl, mit 1 bis 6 C-Atomen, Benzyl, Trimethylen oder Tetramethylen. Bevorzugter ist der Substituent Alkyl, Alkoxy oder Alkoxyalkyl mit 1 bis 6 C-Atomen, Benzyl, Trimethylen oder Tetramethylen. Ganz besonders ist der Substituent $C_1$-$C_4$-Alkyl. Als Alkoxyalkyl ist Alkoxymethyl bevorzugt und als Alkoxy Methoxy. Beispiele für den Substituenten sind: Methyl, Aethyl, Propyl, Isopropyl, n-Butyl, Isobutyl, Tertiärbutyl, Pentyl, Hexyl, Octyl, Dodecyl, Tetradecyl, Eicosyl, Cyclopentyl, Cyclohexyl, Methylcyclohexyl, Methoxy, Aethoxy, Propoxy, Butoxy, Pentoxy, Hexoxy, Methoxmethyl, Methoxyäthyl, Aethoxymethyl, Propoxymethyl, Butoxymethyl, Benzyl, Methylbenzyl, Phenyläthyl, Methylthio, Aethylthio, Hydroxyäthyl, Methylthioäthyl und Hydroxyäthylthio. Bevorzugte Reste sind Methoxymethyl, Aethoxymethyl, Methyl, Aethyl, n-Propyl, i-Propyl, Trimethylen und Tetramethylen, Cyclopentyl und Cyclohexyl. Besonders bevorzugt ist Methyl, Aethyl und i-Propyl. Bei dem substituierten aromatischen Rest kann es sich um einkernige oder mehrkernige, besonders zweikernige Reste handeln. Einkernige Reste können 1 bis 4, bevorzugt 1 oder 2, Substituenten enthalten und zweikernige Reste können 1 bis 4, bevorzugt 1 oder 2 Substituenten in jedem Kern enthalten. Es wurde gefunden, dass die Lichtempfindlichkeit von Homo- oder Copolymeren besonders hoch ist, wenn ein oder zwei Substituenten in Orthostellung zum N-Atom gebunden sind. Die Substitution in Orthostellung ist daher bevorzugt. Der aromatische Rest ist bevorzugt in Meta- oder Parastellung zum N-Atom gebunden.

R bzw. R' kann als aromatischer Rest 7 bis 30, besonders 7 bis 20 C-Atome enthalten. Der aromatische Rest ist bevorzugt ein Kohlenwasserstoffrest oder Pyridinrest, der wie zuvor definiert substituiert ist.

Eine bevorzugte Untergruppe sind solche aromatische Reste der Formeln

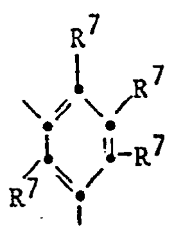 , 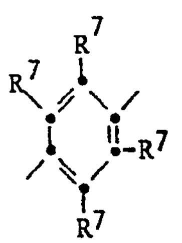 , 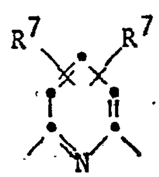 ,

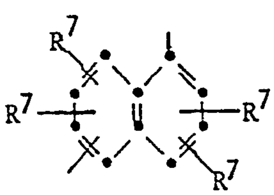 , 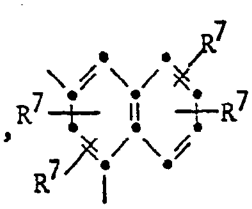 , 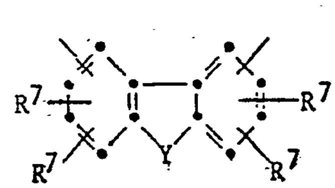 ,

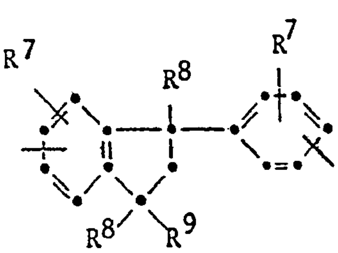 oder

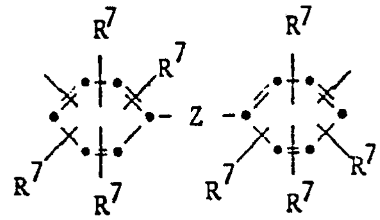

,

worin $R^7$ im Falle der Monosubstitution Alkyl mit 1 bis 6 C-Atomen und die anderen $R^7$ Wasserstoff sind, und im Falle der Di-, Tri- oder Tetrasubstitution zwei $R^7$ Alkyl mit 1 bis 6 C-Atomen und die anderen $R^7$ ein Wasserstoffatom oder Alkyl mit 1 bis 6 C-Atomen sind oder im Falle der Di-, Tri- oder Tetrasubstitution zwei vicinale $R^7$ im Phenylring für Trimethylen oder Tetramethylen und die anderen $R^7$ für ein Wasserstoffatom oder Alkyl mit 1 bis 6 C-Atomen stehen, Y für O, S, NH, CO oder $CH_2$ steht, $R^8$ ein Wasserstoffatom oder Alkyl mit 1 bis 5 C-Atomen und $R^9$ Alkyl mit 1 bis 5 C-Atomen darstellt, und Z eine direkte Bindung, 0, S, SO, $SO_2$, CO,

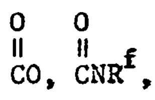

$NR^f$, CONH, NH, $R^{10}SiR^{11}$, $R^{10}OSiOR^{11}$,

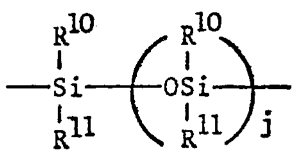

Alkylen mit 1 bis 6 C-Atomen, das durch -O- oder -S- unterbrochen sein kann, Alkenylen oder Alkyliden mit 2 bis 6 C-Atomen, Phenylen oder Phenyldioxyl bedeutet, worin $R^{10}$ und $R^{11}$ unabhängig voneinander Alkyl mit 1 bis 6 C-Atomen oder Phenyl bedeuten und j für 1-10, besonders 1-3 steht und $R^f$ $C_1$-$C_6$-Alkyl, Phenyl oder Benzyl ist. Z kann weiter der Formel

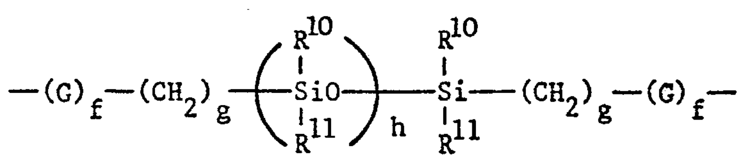

entsprechen worin G für S und besonders für O steht, f O oder besonders 1, g 1 bis 6 und h 1 bis 50, besonders 1 bis 10 bedeuten, und $R^{10}$ und $R^{11}$ die zuvor angegebene Bedeutung haben, sowie einem Rest der Formel

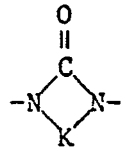

entsprechen, worin K für

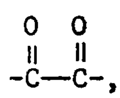, 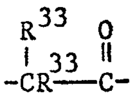 oder 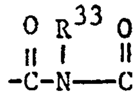

mit $R^{33}$ gleich H, $C_1$-$C_6$-Alkyl oder Phenyl steht. $R^8$ und $R^9$ sind bevorzugt Methyl, Y steht bevorzugt für $-CH_2-$ oder -O- und Z bevorzugt für eine direkte Bindung, -O-, $-CH_2-$ oder Alkyliden mit 2 bis 4 C-Atomen. $R^{10}$ und $R^{11}$ stehen besonders für Methyl, Aethyl und Phenyl. Das Alkylen enthält bevorzugt 2 bis 4 C-Atome und ist besonders Aethylen. Alkenylen ist besonders Aethenylen.

Eine bevorzugte Untergruppe sind Toluylenreste, Reste O,O'-substituierter Diaminodiphenylene, Diaminodiphenylmethane und Diaminodiphenyläther.

Eine besonders bevorzugte Gruppe sind solche aromatischen Reste der Formeln

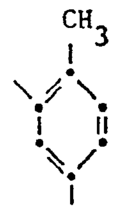, 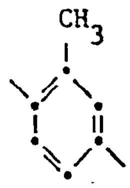, 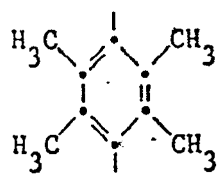, 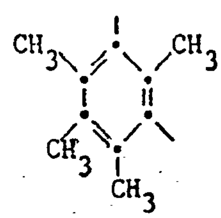

oder 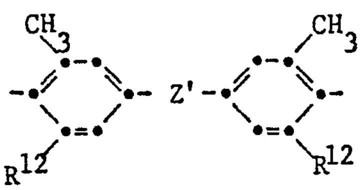

worin Z'eine direkte Bindung, 0 und besonders $CH_2$ bedeutet und $R^{12}$ ein Wasserstoffatom, Methyl, Aethyl oder Isopropyl darstellt.

Beispiele für substituierte aromatische Reste sind: 4-Methyl-1,3-phenylen, 4-Aethyl-1,3-phenylen, 2-Methyl-1,3-phenylen, 4-Benzyl-1,3-phenylen, 4-Methoxymethyl-1,3-phenylen, Tetrahydro-1,3- oder -1,4-naphthylen, 3-Propyl-1,3- oder -1,4-phenylen, 3-Isopropyl-1,4-phenylen, 3,5-Dimethyl-1,4-phenylen, 2,4-Dimethyl-1,3-phenylen, 2,3-Dimethyl-1,4-phenylen, 5-Methyl-1,3-phenylen, Tetramethyl-1,4- oder -1,3-phenylen, 3-Methyl-2,6-pyridylen, 3,5-Dimethyl-2,6-pyridylen, 3-Aethyl-2,6-pyridylen, 1-Methyl-2,7-naphthylen, 1,6-Dimethyl-2,7-naphthylen, 1-Methyl-2,4-naphthylen, 1,3-Dimethyl-2,4-naphthylen, die zweiwertigen Reste von 5-Amino-1-(3'-amino-4'-methylphenyl)-1,3,3-trimethylindan oder 6-Amino-5-methyl-1-(3'-amino-4'-methyl)-1,3,3-trimethylindan, 4-Methoxymethyl-1,3-phenylen, 3-Methyl-biphen-4,4'diyl, 3-Aethyl-biphen-4,4'-diyl,3,3'-Dimethyl-biphen-4,4'-diyl, 3,3'-Diäthyl-biphen-4,4'-diyl, 3-Methyl-3'-äthyl-biphen-4,4'diyl,3,3',5,5'-Tetramethyl-biphen diyl, 3,3'-Dimethyl-5,5'-diäthyl-biphen-4,4'-diyl, 4,4'-Dimethyl-biphen-3,3'-diyl, 3,3'-Diisopropyl-biphendiyl, Reste der Formeln

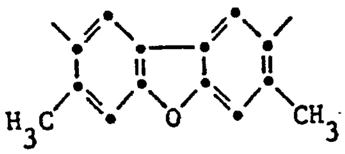 , 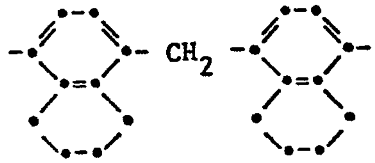 ,

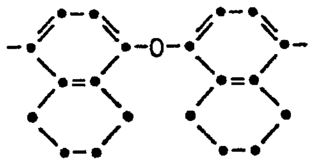 , 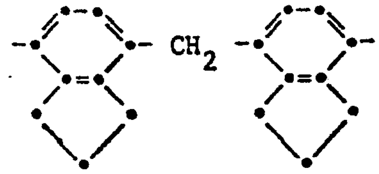 ,

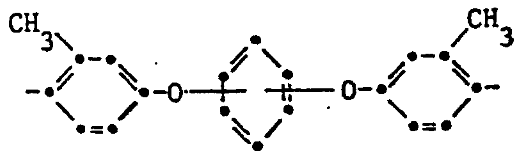

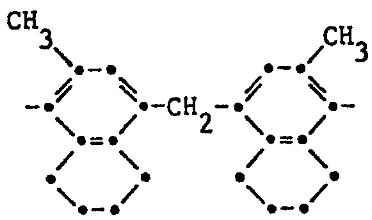 , 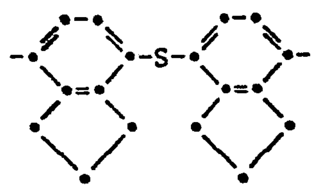 ,

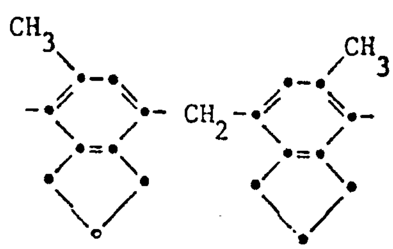 , 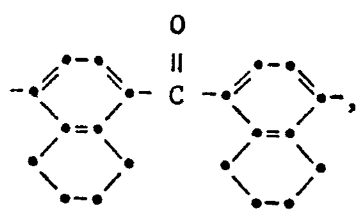,

sowie

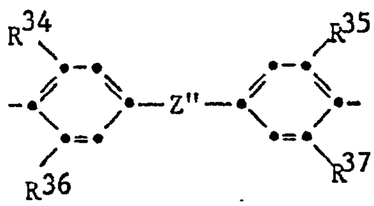 , 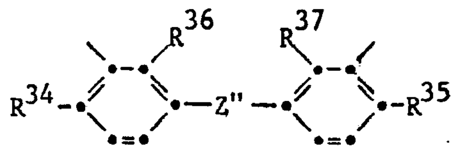

und 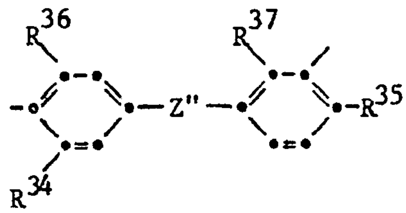

worin Z", $R^{34}$, $R^{35}$, $R^{36}$ und $R^{37}$ die in nachfolgender Tabelle angegegenen Bedeutungen haben. Die Phenylkerne können hierbei mit weiteren 1 oder 2 Resten substituiert sein, z.B. solchen mit der Bedeutung von $R^{34}$ bis $R^{37}$. Beispiele für solche Diaminoreste sind nachfolgend für die erfindungsgemässen Homo- und Copolyimide genannt.

| Z" | $R^{34}$ | $R^{35}$ | $R^{36}$ | $R^{37}$ |
|---|---|---|---|---|
| $CH_2$ | Aethyl | Aethyl | H | H |
| $CH_2$ | Benzyl | Benzyl | H | H |
| $CH_2$ | Methyl | Methyl | H | H |
| $CH_2$ | Aethyl | Aethyl | H | H |
| $CH_2$ | Isopropyl | Isopropyl | H | H |
| $CH_2$ | Methoxymethyl | | H | H |
| $CH_2$ | Methyl | Aethyl | H | H |
| $CH_2$ | Methoxymethyl | | Methoxymethyl | |
| $CH_2$ | Methyl | Methyl | Methyl | Methyl |
| $CH_2$ | Aethyl | Aethyl | Aethyl | Aethyl |
| $CH_2$ | Methyl | Methyl | Aethyl | Aethyl |
| $CH_2$ | Aethyl | Aethyl | Isopropyl | Isopropyl |
| $CH_2$ | Isopropyl | Isopropyl | Isopropyl | Isopropyl |
| $CH_2$ | Isopropyl | Isopropyl | H | H |
| $CH_2$ | Methoxy | Methoxy | H | H |
| O | Aethyl | Aethyl | H | H |
| O | Methyl | Methyl | H | H |
| O | Methyl | Methyl | Methyl | Methyl |
| O | Methyl | Methyl | Aethyl | Aethyl |

| Z" | $R^{34}$ | $R^{35}$ | $R^{36}$ | $R^{37}$ |
|---|---|---|---|---|
| S | Aethyl | Aethyl | H | H |
| S | Methyl | Methyl | H | H |
| S | Methyl | Methyl | Methyl | Methyl |
| S | Aethyl | Aethyl | Aethyl | Aethyl |
| S | Methyl | Methyl | Aethyl | Aethyl |
| CO | Methyl | Methyl | H | H |
| CO | Methyl | Methyl | Methyl | Methyl |
| $SO_2$ | Methyl | Methyl | H | H |
| $SO_2$ | Methyl | Methyl | Methyl | Methyl |
| $SO_2$ | Aethyl | Aethyl | Methyl | Methyl |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | H | H |
| $NCH_3$ | Methyl | Methyl | Methyl | Methyl |
| CONH | Methyl | Methyl | H | H |
| NH | Aethyl | Aethyl | H | H |
| NH | Methyl | Methyl | H | H |

| Z'' | $R^{34}$ | $R^{35}$ | $R^{36}$ | $R^{37}$ |
|---|---|---|---|---|
| $Si(Methyl)_2$ | Methyl | Methyl | H | H |
| $Si(Phenyl)_2$ | Methyl | Methyl | Methyl | Methyl |
| $Si(OMethyl)_2$ | Aethyl | Aethyl | H | H |
| $Si(OPhenyl)_2$ | Methyl | Methyl | H | H |
| Aethylen | Methyl | Methyl | H | H |
| Aethylen | Methyl | Methyl | Methyl | Methyl |
| Aethylen | Aethyl | Aethyl | H | H |
| ~~Aethylen~~ | ~~Methyl~~ | ~~Methyl~~ | ~~-~~ | |
| Phenylen | H | H | Methyl | Methyl |
| Phenylen | Alkyl | Alkyl | H | H |
| $(CH_3)_2C<$ | Methyl | Methyl | H | H |
| $(CH_3)_2C<$ | Methyl | Methyl | Methyl | Methyl |
| $(CF_3)_2C<$ | Methyl | Methyl | Methyl | Methyl |

Die Diamine, von denen sich R bzw. R' ableiten, sind bekannt oder können nach bekannten Verfahren hergestellt werden. Diamine mit Polysiloxaneinheiten sind aus der US-PS 3 435 002 und aus der EP-A- 0 054 426 bekannt. Diamine mit der

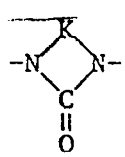

Gruppe sind in der DE-A-2 318 170 beschrieben. Die erfindungsgemässen Homo- und Copolymeren werden nach üblichen Verfahren in hierfür vorgesehenen Einrichtungen hergestellt. Die Polymeren sind vorzugsweise linear aufgebaut. Sie können aber auch mit geringen Mengen mindestens trifunktioneller Verbindungen verzweigt sein.

Die Homo- oder Copolymeren sind bevorzugt ausgewählt aus der Gruppe der Polyimide, Polyamide, gesättigte Polyester, Polycarbonate, Polyamidimide, Polyesterimide, Polyesteramide, Polysiloxane, ungesättigten Polyester, Epoxidharze, der aromatischen Polyäther, der aromatischen Polyätherketone, der aromatischen Polyäthersulfone, der aromatischen Polyketone, der aromatischen Polythioäther, der aromatischen Polyimidazole, der aromatischen Polypyrrone oder Gemischen dieser Polymeren.

Ganz besonders bevorzugt sind unter diesen Polymeren ein Homo- oder Copolyimid mit 5 bis 100 Mol-% Strukturelementen der Formeln I und/oder II, worin q = O ist, und R ein aromatischer Rest ist, der in beiden Orthostellungen mindestens eines N-Atomes durch Alkyl, Cycloalkyl, Alkoxy, Alkoxyalkyl, Alkylthio, Alkylthioalkyl, Aralkyl oder zwei benachbarte C-Atome des aromatischen Restes durch Alkylen substituiert

sind, und 0 bis 95 Mol-% Strukturelementen der Formel III

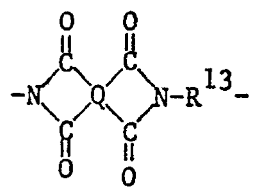

(III)

worin Q ein vierwertiger organischer Rest und $R^{13}$ ein zweiwertiger organischer Rest sind oder $R^{13}$ die Bedeutung von R hat.

R und $R^{13}$ stellen in den Copolyimiden besonders aromatische organische Reste dar. Von diesen Copolyimiden sind besonders solche bevorzugt, die mindestens 50 Mol-%, vorzugsweise 80 Mol-% Strukturelemente der Formeln I und/oder II enthalten.

Es ist bekannt, dass einige aliphatische und aromatische Diamine, z.B. Phenylendiamin oder Di-(aminophenyl)methan, die Unlöslichkeit von Polyimiden fördern können. Solche Diamine werden daher bevorzugt in geringeren Mengen eingesetzt. Insbesondere sind für diesen Fall die Strukturelemente der Formeln I und/oder II zu mindestens 50 Mol-%, besoners 80 Mol-% und ganz besonders 90 Mol-% enthalten.

Q enthält als vierwertiger aromatischer Rest bevorzugt 6 bis 30, besonders 6 bis 20 C-Atome.

Q in Formel III kann aus den folgenden Gruppen ausgewählt sein: aromatische, aliphatische, cycloaliphatische, heterocyclische Gruppen, Kombinationen von aromatischen und aliphatischen Gruppen. Die Gruppen können auch substituiert sein. Die Gruppe Q kann durch die folgenden Strukturen gekennzeichnet sein:

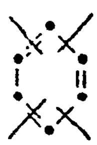 , 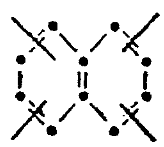 ,

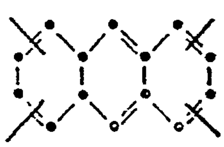 , 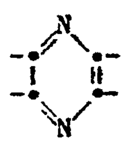 , 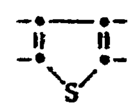

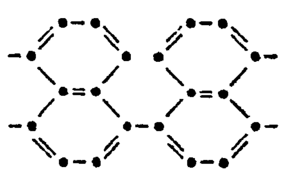 , 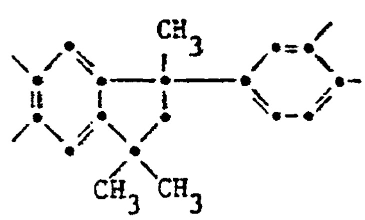

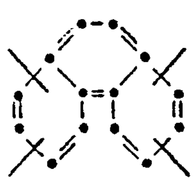 , 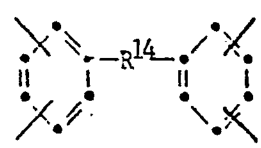

worin $R^{14}$ eine direkte Bindung oder eine Brückengruppe der Formeln

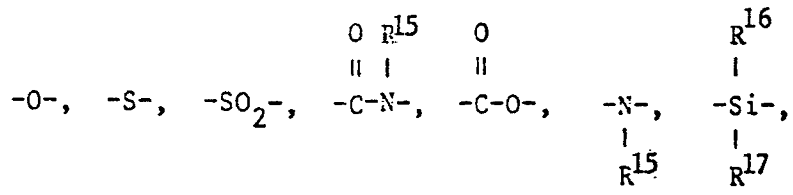

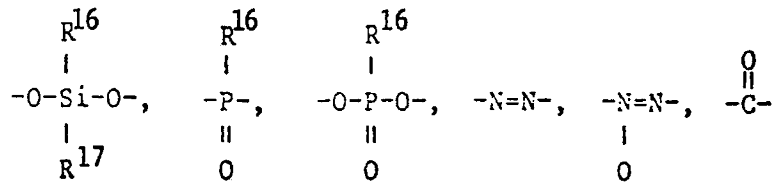

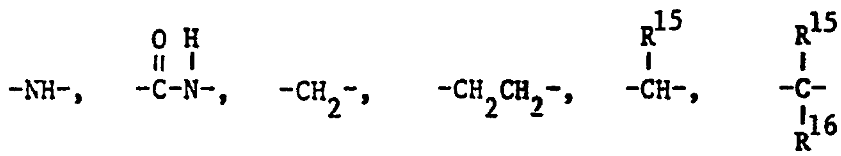

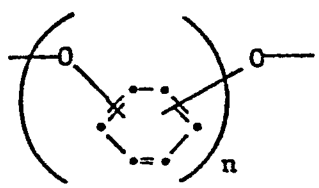 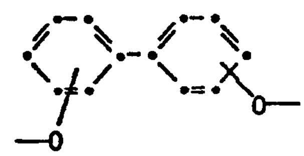

ist, worin $R^{15}$, $R^{16}$ und $R^{17}$ Alkyl mit 1 bis 6 C-Atomen, Phenyl oder Benzyl und $R^{16}$ und $R^{17}$ Alkoxy mit 1 bis 6 C-Atomen, Phenyloxy oder Benzyloxy sind.

In den vorausstehenden Formeln befinden sich stets je zwei der freien Bindungen in Orthostellung, und/oder bei der Naphthalin-derivaten in Peristellung.

Eine bevorzugte Untergruppe für Q sind Reste der Formeln

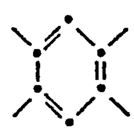 oder 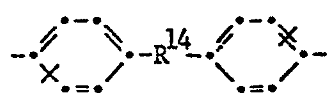 ,

worin $R^{14}$ eine direkte Bindung, -O-, -SO-, $-CH_2-$ und besonders -CO- ist.

Ganz besonders bevorzugt sind Reste der Formeln

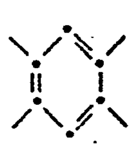 und 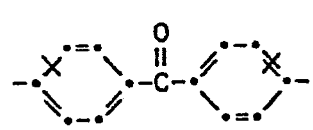

oder Mischungen davon, z.B. solche mit mindestens 5 Mol-% vierwertigen Benzophenonresten. Die freien Bindungen im Benzophenonrest befinden sich in Orthostellung.

Beispiele für Tetracarbonsäureanhydride mit einem Rest Q sind:
2,3,9,10-Perylentetracarbonsäuredianhydrid,
1,4, 5,8-Naphthalintetracarbonsäuredianhydrid,
2,6-Dichlornaphthalin-1,4,5,8-tetracarbonsäuredianhydrid,

2,7-Dichlornaphthalin-1,4,5,8-tetracarbonsäuredianhydrid,
2,3,6,7-Tetrachlornaphthalin-1,4,5,8-tetracarbonsäuredianhydrid,
Phenanthren-1,8,9,10-tetracarbonsäuredianhydrid,
Pyromellitsäuredianhydrid,
3,3',4,4'-Biphenyltetracarbonsäuredianhydrid,
2,2',3,3'-Biphenyltetracarbonsäuredianhydrid,
4,4'-Isopropylidendiphthalsäureanhydrid,
3,3'-Isopropylidendiphthalsäureanhydrid,
4,4'-Oxydiphthalsäureanhydrid,
4,4'-Sulfonyldiphthalsäureanhydrid,
3,3'-Oxydiphthalsäureanhydrid,
4,4'-Methylendiphthalsäureanhydrid,
4,4'-Thiodiphthalsäureanhydrid,
4,4'-Aethylidendiphthalsäureanhydrid,
2,3,6,7-Naphthalintetracarbonsäuredianhydrid,
1,2,4,5-Naphthalintetracarbonsäuredianhydrid,
1,2,5,6-Naphthalintetracarbonsäuredianhydrid,
Benzol-1,2,3,4-tetracarbonsäuredianhydrid,
Thiophen-2,3,4,5-tetracarbonsäuredianhydrid,
1-(3',4'-Dicarboxyphenyl)-1,3,3-trimethylindan-5,6-dicarbonsäuredianhydrid,
1-(3',4'-Dicarboxyphenyl)-1,3,3-trimethylindan-6,7-dicarbonsäuredianhydrid,
1-(3',4'-Dicarboxyphenyl)-3-methylindan-5,6-dicarbonsäuredianhydrid,
1-(3',4'-Dicarboxyphenyl)-3-methylindan-6,7-dicarbonsäuredianhydrid,
3,3',4,4'-Benzophenontetracarbonsäureanhydrid,
4,5,3',4'-Benzophenontetracarbonsäureanhydrid.

Als aromatischer Rest stellt R in den Polyimiden bevorzugt einen zweiwertigen, ein- oder zweikernigen Phenylenrest dar. Die Substituenten von R können als lineares oder verzweigtes Alkyl und Alkoxy 1 bis 20, bevorzugt 1 bis 6 und besonders 1 bis 4 C-Atome, als lineares oder verzweigtes Alkoxyalkyl 2 bis 12, besonders 2 bis 6 C-Atome, als Alkylen 3 oder 4 C-Atome, als Cycloalkyl 5 bis 8, besonders 5 oder 6 Ringkohlenstoffatome und als Aralkyl 7 bis 12 C-Atome enthalten. Das Alkoxyalkyl ist bevorzugt Alkoxymethyl und das Aralkyl Benzyl.

Beispiele für Substituenten von aromatischen Resten R sind weiter oben aufgeführt. Besonders bevorzugt ist Isopropyl, Aethyl und insbesondere Methyl.

R kann als substituierter aromatischer Rest 7 bis 30, besonders 8 bis 25 C-Atome enthalten. Der aromatische Rest ist bevorzugt ein Pyridinrest und besonders ein Kohlenwasserstoffrest, der durch Alkyl, Alkoxyalkyl, Alkoxy, Trimethylen oder Tetramethylen substituiert ist. Der aromatische Rest kann weitere Substituenten enthalten, z.B. Halogenid wie Cl oder Br. In einer bevorzugten Untergruppe sind die aromatischen Reste als einkernige Reste Phenylenreste und als zweikernige Reste Naphthylen oder Bisphenylenreste.

Eine bevorzugte Untergruppe von erfindungsgemässen Polyimiden sind solche, in denen R als aromatischer Rest den Formeln IV, IVa und/oder IVb entspricht,

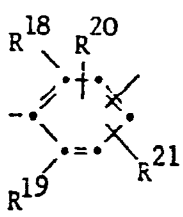 (IV) 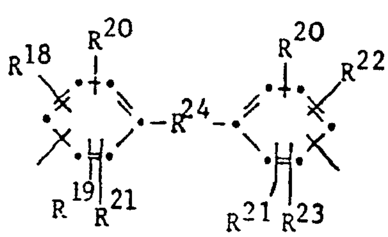 (IVa) 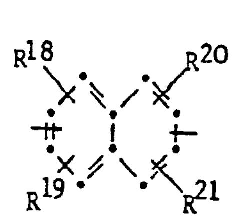 (IVb)

worin in Formel IV die freien Bindungen in Meta- oder Parastellung zueinander stehen, in Formel IVa die freien Bindungen bevorzugt in Meta- oder Parastellung zur $R^{24}$-Gruppe stehen und $R^{18}$ und $R^{19}$ in den beiden Orthostellungen der freien Bindung gebunden sind, und in Formel IVb die freien Bindungen in 2-, 3-, 6- und 7-Stellung gebunden sind und $R^{18}$ und $R^{19}$ sich in den beiden Orthostellungen der freien Bindung befinden, $R^{24}$ für eine direkte Bindung, -O-, -S-, -SS-, -SO-, $-SO_2-$, -CO-, -COO-, -NH-, -N-Alkyl mit 1 bis 6 C-Atomen im Alkyl,

-N-Phenyl, -N-Benzyl,

-CONH-, -CON-Alkyl- mit 1 bis 6 C-Atomen im Alkyl, -CON-Phenyl-, -CON-Benzyl-,

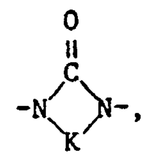

worin K für

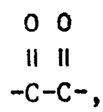 , 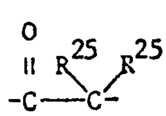 oder 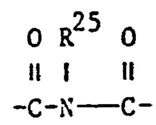

steht und $R^{25}$ ein Wasserstoffatom, $C_1$-$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy,
oder die Gruppe

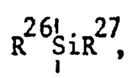

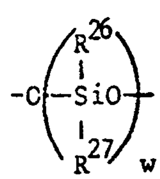 oder 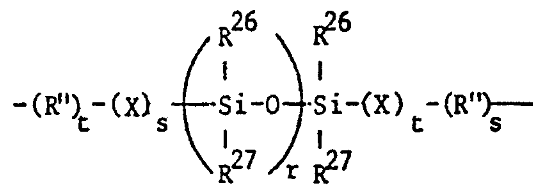

steht, worin $R^{26}$ und $R^{27}$ Alkyl oder Alkoxy mit 1 bis 6 C-Atomen, Phenyl, Benzyl, Phenyloxy oder Benzyloxy sind, r eine Zahl von 1 bis 10, t 0 oder 1 und s 0 oder 1 ist, und R" -O- oder -S- und X $C_1$-$C_6$-Alkylen bedeuten, und w für eine Zahl von 1 bis 100 steht, $R^{18}$ und $R^{19}$ Alkyl, oder Alkoxy mit 1 bis 12 C-Atomen, Alkoxyalkyl mit 2 bis 12 C-Atomen Cyclopentyl, Cyclohexyl oder Benzyl sind oder in den Formeln IV oder IVa $R^{18}$ und $R^{20}$ in Nachbarstellung gebunden sind und zusammen Trimethylen oder Tetramethylen bedeuten, wobei $R^{19}$ auch ein Wasserstoffatom sein kann, $R^{20}$ und $R^{21}$ ein Wasserstoffatom sind oder unabhängig die Bedeutung von $R^{18}$ und $R^{19}$ haben, und $R^{22}$ und $R^{23}$ ein Wasserstoffatom sind, unabhängig die Bedeutung von $R^{18}$ und $R^{19}$ haben oder $R^{20}$ und $R^{22}$ in Formel IVa zusammen Trimethylen oder Tetramethylen sind. $R^{18}$ und $R^{19}$ sind bevorzugt Alkyl mit 1 bis 6 C-Atomen, besonders Methyl, Aethyl, n-Propyl und Isopropyl. Die freien Bindungen der Formel IVa befinden sich bevorzugt in Meta- und besonders Parastellung zur $R^{24}$-Gruppe. Das Alkyl in den $R^{24}$-Resten kann z.B. Methyl, Aethyl, Propyl, Isopropyl, n-Butyl oder Pentyl sein. $R^{24}$ als Alkylen ist bevorzugt Aethylen und besonders Methylen. Als Alkyliden enthält $R^{24}$ bevorzugt 2 bis 6 C-Atome. Beispiele sind Aethyliden, 2,2-Butyliden, 2,2- oder 3,3-Pentyliden, Hexafluorpropyliden und besonders 2,2-Propyliden. $R^{24}$ als Cycloalkyliden kann z.B. Cyclopentyliden und besonders Cyclohexyliden sein. Die $R^{24}$-Gruppe ist bevorzugt eine direkte Bindung, -O-, -S-, $-SO_2-$, -CO-, Alkylen und Alkyliden. Besonders bevorzugt ist $R^{24}$ eine direkte Bindung oder -O-, und insbesondere -CO- oder $-CH_2-$. $R^{26}$ und $R^{27}$ sind bevorzugt Alkyl, besonders Methyl oder Phenyl. R" steht bevorzugt für -O- und X bevorzugt für Methylen oder Aethylen, w ist bevorzugt eine Zahl von 1 bis 10 und r eine Zahl von 1-20, besonders 1-10.

Eine weitere Gruppe von Diaminresten sind solche der Formel

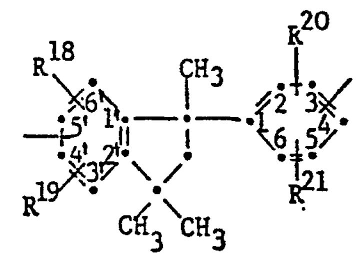,

worin die freie Bindung in 4'- oder 5'-Stellung gebunden ist und die andere in 3-, 5-, und bevorzugt 4-Stellung, $R^{18}$ und $R^{19}$ und/oder $R^{20}$ und $R^{21}$ sich in den Orthostellungen der freien Bindung befinden und für Alkyl oder Alkoxy mit 1 bis 12 C-Atomen oder Alkoxyalkyl mit 2 bis 12 C-Atomen stehen.

Eine besonders bevorzugte Untergruppe von erfindungsgemässen Polyimiden sind jene, in denen R in Formel I und/oder II Resten der Formeln

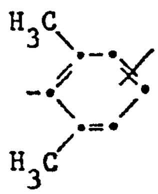, 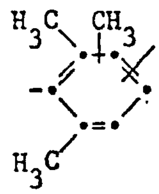, 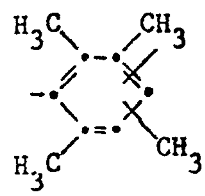, 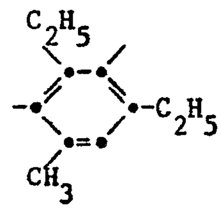

entspricht, worin die freien Bindungen in Meta- oder Parastellung zueinander stehen, oder der Formel

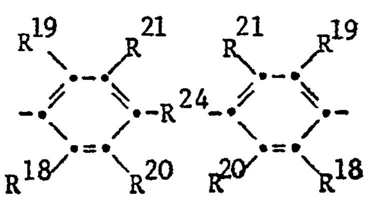

entsprechen, worin $R^{18}$ und $R^{19}$ unabhängig Methyl, Aethyl, n-Propyl oder Isopropyl und $R^{20}$ und $R^{21}$ ein Wasserstoffatom sind oder die Bedeutung von $R^{18}$ haben oder $R^{18}$ und $R^{20}$ zusammen Tri- oder Tetramethylen bedeuten und $R^{19}$ und $R^{21}$ ein Wasserstoffatom sind, und $R^{24}$ eine direkte Bindung, $CH_2$, 2,2-Propyliden oder CO ist. Unter diesen zweikernigen Resten sind besonders solche bevorzugt, in denen $R^{18}$, $R^{19}$, $R^{20}$ und $R^{21}$ für Methyl stehen. Copolyimide, die mindestens 2 verschiedene Reste dieser Formeln enthalten, sind eine weitere bevorzugte Ausführungsform der Erfindung.

Erfindungsgemässe Copolyimide enthalten mindestens zwei verschiedene Strukturelemente, wobei sich die Anzahl an verschiedenen Strukturelementen im wesentlichen nach den gewünschten Eigenschaften und dem Anwendungsgebiet richten. Bevorzugt enthalten sie 2 bis 4 verschiedene Strukturelemente, wobei sich die Strukturelemente nur im Rest R der Formeln I und/oder II unterscheiden können. In einer besonders bevorzugten Ausführungsform solcher Copolyimide sind Strukturelemente von Orthodisubstituierten Phenylenen enthalten, besonders von 1,3-Phenylenen.

Beispiele für R in erfindungsgemässen Polyimiden sind: 2,6-Dimethyl-1,4- oder 1,3-phenylen, 2,6-Diäthyl-1,4- oder 1,3-phenylen, 2,6-Dimethyl-5-chlor-1,4- oder 1,3-phenylen, 2-Methyl-6-äthyl-1,4- oder 1,3-phenylen, 2-Methyl-6-isopropyl-1,4- oder 1,3-phenylen, 2,6-Diisopropyl-1,4- oder 1,3-phenylen, 2,6-Dimethoxy-1,4-oder 1,3-phenylen, 2,6-Diäthoxy-1,4- oder 1,3-phenylen, 2-Methyl-6-methoxy-1,4- oder 1,3-phenylen, 2,6-Dibenzyl-1,4- oder 1,3-phenylen, 2,6-Dimethoxymethyl-1,4- oder 1,3-phenylen, 2,5,6-Trimethyl-1,4- oder 1,3-phenylen, 2,5,6-Triäthyl-1,4- oder 1,3-phenylen, 2,4,6-Trimethyl-1,3-phenylen, 2,3,5,6-Tetramethyl-1,4-phenylen, 2,4,5,6-Tetramethyl-1,3-phenylen, Tetrahydro-1,4- oder 1,3-naphthylen, Reste der Formeln

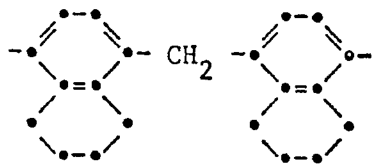 , 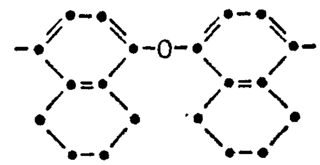 ,

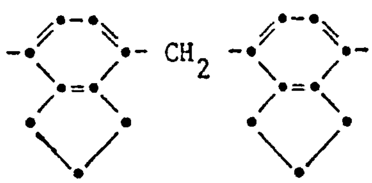 , 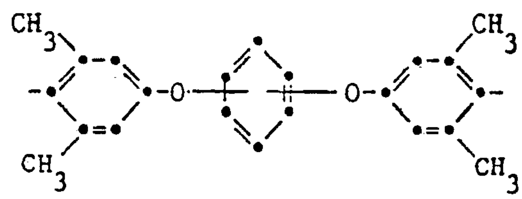

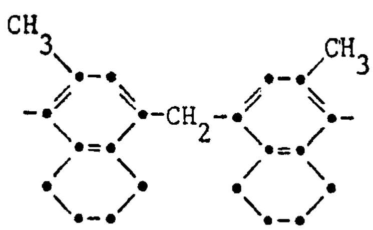 , 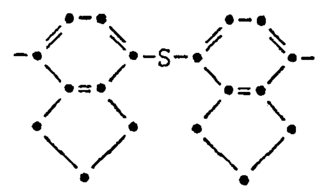 ,

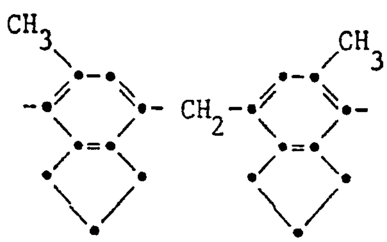 , 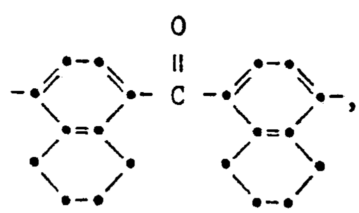 ,

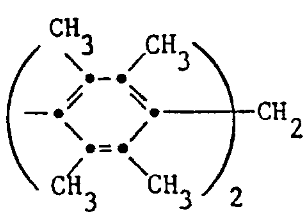 , 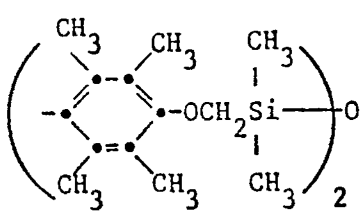 , 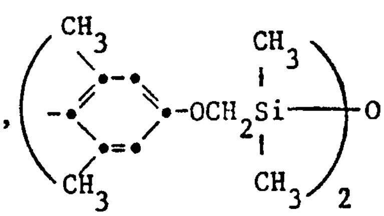 ,

sowie

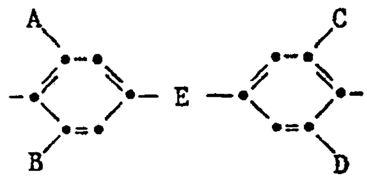
,
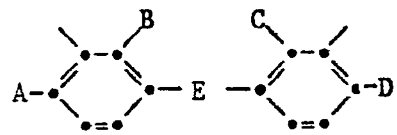

und

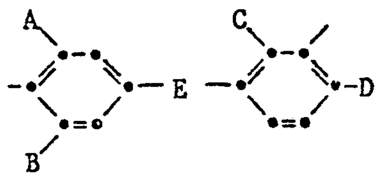

worin A, B, C, D und E die in nachfolgender Tabelle angegebenen Bedeutungen haben. Die freien Positionen in den Phenylkernen können hierbei durch einen oder zwei weitere Substituenten G oder H in jedem Kern besetzt sein, wobei G oder H die in nachfolgender Tabelle angegebene Bedeutung für A bis D haben können:

| E | A | B | C | D |
|---|---|---|---|---|
| $CH_2$ | Methyl | Methyl | H | H |
| $CH_2$ | Methyl | Aethyl | H | H |
| $CH_2$ | Aethyl | Aethyl | H | H |
| $CH_2$ | Isopropyl | Isopropyl | H | H |
| $CH_2$ | Methoxymethyl | | H | H |
| $CH_2$ | Benzyl | Benzyl | H | H |
| $CH_2$ | Methyl | Methyl | Methyl | H |
| $CH_2$ | Aethyl | Aethyl | Aethyl | H |
| $CH_2$ | Isopropyl | Isopropyl | Methyl | Methyl |
| $CH_2$ | Methoxymethyl | | Methyl | H |
| $CH_2$ | Methyl | Aethyl | Methyl | H |
| $CH_2$ | Methoxymethyl | | Methoxymethyl | |
| $CH_2$ | Methyl | Methyl | Methyl | Methyl |
| $CH_2$ | Aethyl | Aethyl | Aethyl | Aethyl |
| $CH_2$ | Methyl | Methyl | Aethyl | Aethyl |
| $CH_2$ | Aethyl | Aethyl | Isopropyl | Isopropyl |
| $CH_2$ | Isopropyl | Isopropyl | Isopropyl | Isopropyl |
| $CH_2$ | Isopropyl | Isopropyl | Methyl | H |
| $CH_2$ | Methoxy | Methoxy | Methyl | Methyl |
| O | Methyl | Methyl | H | H |
| O | Aethyl | Aethyl | H | H |
| O | Methyl | Methyl | Methyl | H |
| O | Methyl | Methyl | Methyl | Methyl |
| O | Methyl | Methyl | Aethyl | Aethyl |
| S | Methyl | Methyl | H | H |

| E | A | B | C | D |
|---|---|---|---|---|
| S | Aethyl | Aethyl | H | H |
| S | Methyl | Methyl | H | H |
| S | Methyl | Methyl | Methyl | Methyl |
| S | Aethyl | Aethyl | Aethyl | Aethyl |
| S | Methyl | Methyl | Aethyl | Aethyl |
| CO | Methyl | Methyl | Methyl | H |
| CO | Methyl | Methyl | H | H |
| CO | Methyl | Methyl | Methyl | Methyl |
| $SO_2$ | Methyl | Methyl | Aethyl | H |
| $SO_2$ | Methyl | Methyl | H | H |
| $SO_2$ | Methyl | Methyl | Methyl | Methyl |
| $SO_2$ | Aethyl | Aethyl | Methyl | Methyl |
| SO | Methyl | Methyl | Methyl | Methyl |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | Aethyl | Aethyl |
| $NCH_3$ | Methyl | Methyl | Methyl | Methyl |
| CONH | Methyl | Methyl | - | - |
| NH | Aethyl | Methyl | Aethyl | Methyl |
| NH | Methyl | Methyl | Methyl | Methyl |

| E | A | B | C | D |
|---|---|---|---|---|
| $Si(Methyl)_2$ | Methyl | Methyl | H | H |
| $Si(Phenyl)_2$ | Methyl | Methyl | Methyl | Methyl |
| $Si(OMethyl)_2$ | Aethyl | Aethyl | H | H |
| $Si(OPhenyl)_2$ | Methyl | Methyl | Methyl | Methyl |
| $-OSi(Methyl)_2O-$ | Methyl | Methyl | Methyl | Methyl |
| Aethylen | Methyl | Methyl | H | H |
| Aethylen | Methyl | Methyl | Methyl | Methyl |
| Aethylen | Aethyl | Aethyl | H | H |
| Aethylen | Methyl | Methyl | Aethyl | Aethyl |
| Phenylen | Methyl | Methyl | Methyl | Methyl |
| Phenylen | Aethyl | Aethyl | H | H |
| $(CH_3)_2C<$ | Methyl | Aethyl | Methyl | Aethyl |
| $(CH_3)_2C<$ | Methyl | Methyl | Methyl | Methyl |
| $(CF_3)_2C<$ | Methyl | Methyl | Methyl | Methyl |
| direkte Bindung | Methyl | Methyl | H | H |
| direkte Bindung | Methyl | Aethyl | Methyl | Aethyl |
| direkte Bindung | Methyl | Aethyl | Methyl | H |
| direkte Bindung | Aethyl | Aethyl | Aethyl | Aethyl |
| direkte Bindung | Methoxy | Methoxy | Methoxy | Methoxy |
| direkte Bindung | Isopropyl | Isopropyl | H | H |
| direkte Bindung | Methoxymethyl | Methoxymethyl | Methoxymethyl | Methoxymethyl |

Die Diamine, von denen sich R ableitet, sind bekannt oder nach bekannten Verfahren herstellbar. Sihaltige Diamine sind in der US-PS 3,435,002 und der EP-A-0 054 426 beschrieben. Diamine mit der

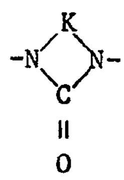

Gruppe können aus den in der DE-A-2 318 170 beschriebenen Diisocyanaten hergestellt werden. Alkyl- oder Cycloalkyl substituierte, besonders Aethyl oder Propyl substituierte Diamine sind durch Alkylierungen von unsubstituierten oder teilsubstituierten aromatischen Diaminen mit Alkenen bzw. Cycloalkenen zugänglich (vgl. US-PS-3 275 690). Mehrkernige, besonders zweikernige aromatische Diamine sind über die Kondensation entsprechender Monoamine mit Aldehyden oder Ketonen erhältlich.

$R^{13}$ kann den zuvor beschriebenen Resten R entsprechen, wobei die aromatischen Reste nicht in beiden o-Stellungen zum N-Atom substituiert sind.

In einer Ausführungsform entspricht $R^{13}$ der Formel V,

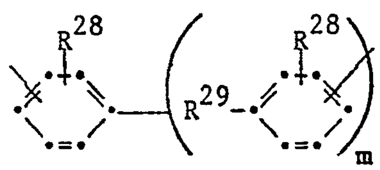 (V)

worin m 0 oder 1 ist, die freien Bindungen in Meta- und bevorzugt in Parastellung zur $R^{29}$ -Gruppe gebunden sind, $R^{29}$ die gleiche Bedeutung wie $R^{24}$ in Formel IVa hat und $R^{28}$ die gleiche Bedeutung wie $R^{18}$ hat.

Eine bevorzugte Untergruppe sind Arylenreste der Formeln Va, Vb oder Vc

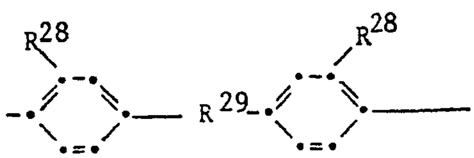 (Va) , 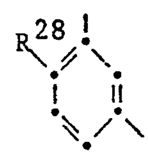 (Vb) ,

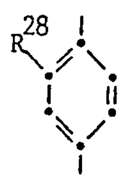 (Vc) ,

worin $R^{29}$ für eine direkte Bindung, -O- -CO- oder $-CH_2-$ steht und $R^{28}$ Methyl, Aethyl, Isopropyl, Methoxy, Aethoxy oder ein Wasserstoffatom bedeutet.

In einer besonders bevorzugten Ausführungsform bestehen erfindungsgemässe Polyimide aus wiederkehrenden Strukturelementen der Formeln

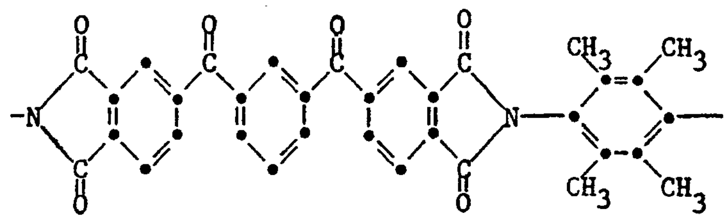

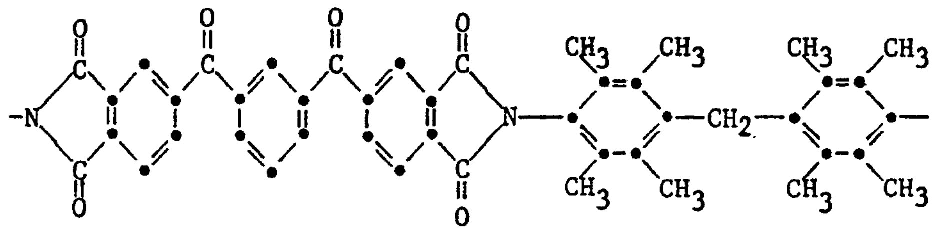

oder Mischungen dieser Strukturelemente.

Die Herstellung der Homo- und Copolyimide erfolgt in üblicher Weise durch Umsetzung von Tetracarbonsäureanhydrid mit Diaminen der Formel $NH_2RNH_2$, gegebenenfalls zusammen mit weiteren Tetracarbonsäureanhydriden der Formel

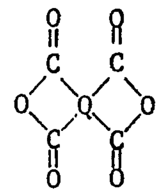

und/oder weiteren Diaminen der Formel $NH_2R^{13}NH_2$, und anschliessende Imidcyclisierung unter Einwirkung von Carbonsäureanhydriden und/oder anschliessendes Erhitzen. Bei einem weiteren bekannten Verfahren werden Diisocyanate mit Tetracarbonsäuredianhydriden direkt zu Polyimiden umgesetzt. Die Polyimide aus den Strukturelementen der Formeln I und II sind wie eingangs erwähnt teilweise bekannt, oder können nach beschriebenen analogen Verfahren hergestellt werden.

Zur Herstellung der anderen ausgewählten Homo- und Copolymeren geht man von funktionellen Imidderivaten der Tetracarbonsäuren aus. Sie können den Formeln VI oder VIa entsprechen,

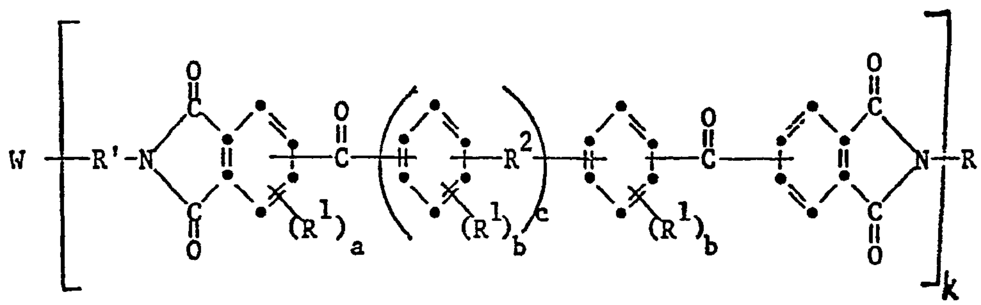

(VI)

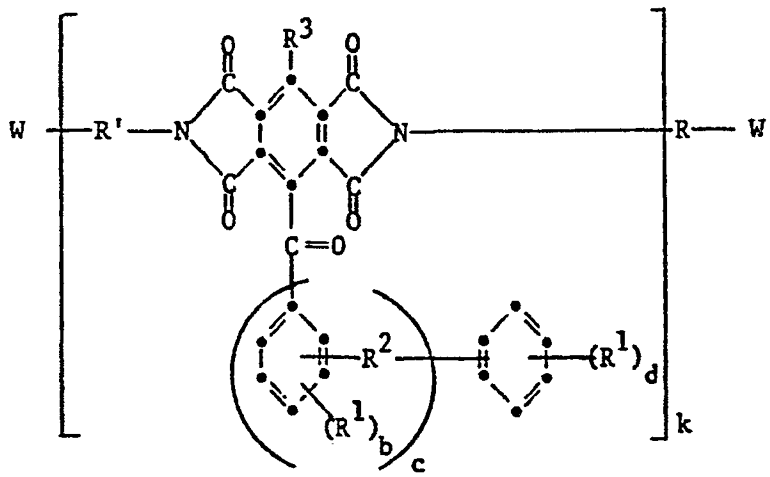

(VIa),

worin R, R', $R^1$-$R^3$ und a - d die zuvor angegebene Bedeutung haben, k eine Zahl von 1 bis etwa 500 und W eine funktionelle Gruppe sind. Solche funktionelle Gruppen können z.B. sein:
$NHR^{38}$ , OH, SH, O-Acyl, $COOR^{38}$, $CON(R^{38})_2$,COCl, COBr,

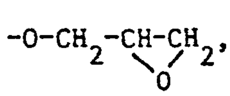, 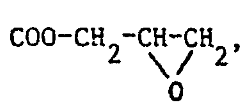, 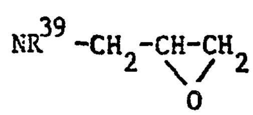

und Halogen, besonders Cl und Br. $R^{38}$ steht für ein Wasserstoffatom oder einen gegebenenfalls hydroxylierten Kohlenwasserstoffrest, z.B. Alkyl oder Hydroxyalkyl mit vorzugswseise 1-20 besonders 1-12 C-Atomen, Aralkyl mit vorzugsweise 7-20, besonders 7-16 C-Atomen, Aryl mit vorzugsweise 6-20, besonders 6-16 C-Atomen oder Cycloalkyl mit vorzugsweise 5-7 Ring-C-Atomen. $R^{39}$ kann die gleiche Bedeutung wie $R^{38}$ haben oder

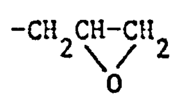

bedeuten. Die Acylgruppe kann 1 bis 20, bevorzugt 1-12 C-Atome enthalten. In den Formeln VI und VIa hat R' bevorzugt die gleiche Bedeutung wie R.

Die Verbindungen der Formeln VI und VIa sind neu. Es handelt sich um oligomere und niedermolekulare Polyimide mit funktionellen Endgruppen. Sie werden nach analogen Verfahren erhalten wie Polyimide, wobei die Grösse von k durch die Menge an miteingesetzten Monomeren der Formel $W\text{-}R\text{-}NH_2$ bestimmt wird. Mit diesen Monomeren (c = 1), Oligomeren und niedermolekularen Polymeren werden z.B. Blockpolymere mit Polyimidblöcken erhalten, die über z.B. Ester-, Amid- oder Imidgruppen verknüpft sind.

Eine weitere bevorzugte Gruppe von erfindungsgemässen Polymeren ist ein Polyamid oder Copolyamid aus organischen Diaminen, Dicarbonsäuren, ω-Aminocarbonsäuren und Diaminen oder Dicarbonsäuren mit Strukturelementen der Formeln I und/oder II, worin q = 1 ist und in denen an die R- und R'-Gruppen Amingruppen oder Carboxylgruppen gebunden sind, sowie aus Mischungen der Monomeren.

Bei den Polymeren kann es sich um solche handeln, deren Molekülketten aus Dicarbonsäuren und

Diaminen der Formeln VI und/oder VIa aufgebaut sind, oder um solche, deren Molekülketten aus Dicarbonsäuren bzw. Diaminen der Formel VI und/oder VIa und anderen organischen Diaminen bzw. Dicarbonsäuren aufgebaut sind. Copolyamide können weitere Diamine- bzw. Dicarbonsäurereste bzw. Aminocarbonsäurereste enthalten.

Geeignete Dicarbonsäuren sind z.B. lineare oder verzweigte aliphatische Dicarbonsäuren mit bevorzugt 2 bis 20, besonders 4 bis 16 C-Atomen, unsubstituierte oder durch besonders Alkyl substituierte cycloaliphatische Dicarbonsäuren mit 5 bis 7 Ring-C-Atomen und unsubstituierte oder z.B. mit Alkyl, Cl oder Brom substituierten aromatischen Dicarbonsäuren mit bevorzugt 8 bis 22 C-Atomen. Beispiele sind: Malonsäure, Adinpinsäure, Trimethyladipinsäure, Pimelinsäure, Korksäure, Azelainsäure, Dodecandicarbonsäure, Cyclohexandicarbonsäuren, Isophthalsäure, Terephthalsäure, p-Diphenyldicarbonsäure, Bis-(4-carboxylphenyl)-äther oder Bis (4-carboxylphenyl-sulfon.

Geeignete Diamine sind z.B. lineare oder verzweigt aliphatische Diamine mit bevorzugt 2 bis 30, besonders 4 bis 20 C-Atomen, unsubstituierte oder durch Alkyl, besonders Methyl substituierte cycloaliphatische Diamine mit bevorzugt 5 bis 7 Ring-C-Atomen, araliphatische Diamine mit bevorzugt 7 bis 24 C-Atomen und aromatische Diamine mit 6 bis 22, vorzugsweise 6 bis 18 C-Atomen, die unsubstituiert oder besonders durch Alkyl substituiert sein können. Beispiele sind: Aethylendiamin, Propylendiamin, 1,3- oder 1,4-Butylendiamin, Pentylendiamin, 1,6-Hexylendiamin, Octylendiamin, Decylendiamin, Dodecylendiamin, 1,10-Alkyl substituierte 1,10-Decylendiamine wie z.B. 1,10-Dimethyl-1,10-decylendiamin oder 1,10-Di-n-Hexyl-1,10-decylendiamin, Xylylendiamin, Isophorondiamin, 1,3- oder 1,4-Cyclohexandiamin, 1,3- oder 1,4-Phenylendiamin, Methylphenylen-diamin, Toluylendiamin, p-Biphenylendiamin, Bis-(p-aminophenyl)äther, Bis-(p-aminophenyl)sulfon, Bis-(-p-aminophenyl)methan.

Bei den Aminocarbonsäuren kann es sich um aromatische, cycloaliphatische oder aliphatische Aminocarbonsäuren handeln, z.B. Aminobenzoesäure, Aminocyclohexancarbonsäure und ω-Aminocarbonsäurenwie ε -Aminocapronsäure oder 11-Aminoundecansäure.

Eine weitere bevorzugte Gruppe von erfindungsgemässen Polymeren ist ein Polyester oder Copolyester aus organischen Diolen, Dicarbonsäuren, Hydroxycarbonsäuren und Diolen oder Dicarbonsäuren mit Strukturelementen der Formeln I und/oder II, worin q = 1 ist und in denen an die R- und R'-Gruppen Hydroxyl oder Carboxylgruppen gebunden sind, sowie aus Mischungen der Monomeren.

Bei den Polyestern kann es sich um solche handeln, deren Molekülketten aus Diolen und Dicarbonsäuren der Formeln VI oder VIa aufgebaut sind, oder um solche, deren Molekülketten aus Dicarbonsäuren oder Diolen der Formeln VI oder VIa und anderen organischen Diolen bzw. Dicarbonsäuren aufgebaut sind. Die Copolyester enthalten weitere Reste von Dicarbonsäuren, Diolen und/oder Hydroxycarbonsäuren.

Geeignete Dicarbonsäuren wurden zuvor erwähnt. Polyester auf der Basis aromatischer Dicarbonsäuren, besonders Terephthalsäure und/oder Isophthalsäure sind bevorzugt. Als Diole kommen cycloaliphatische Diole wie 1,4-Cyclohexandiol, aromatische Diole wie Bisphenol-A und besonders gegebenenfalls substituierte aliphatische Diole wie verzweigte und besonders lineare Alkylendiole mit z.B. 2 bis 12, vorzugsweise 2 bis 6 C-Atomen sowie 1,4-Bis-hydroxymethylcyclohexan und Hydroxypivalinsäureneopentylglycolester in Frage. Besonders bevorzugt sind Aethylen-, Trimethylen-, Tetramethylen- und Hexamethylenglykol. Als Hydroxycarbonsäuren kommen z.B. m- oder p-Hydroxybenzoesäure oder aliphatische ω-Hydroxycarbonsäuren wie z.B. γ-Hydroxyvaleriansäure, -Hydroxypivalinsäure sowie ε-Caprolacton in Frage.

In einer weiteren bevorzugten Ausführungsform sind die erfindungsgemässen Polymeren ein Polyamidimid oder ein Polyesterimid. Solche Polymeren sind durch den Einbau von Tricarbonsäuren der Formel VII oder deren polymerbildenden Derivaten, wie Ester, Anhydrid oder Säurehalogenid, erhältlich:

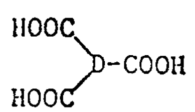

VII.

Der dreiwertige Rest kann ein Kohlenwasserstoffrest mit bevorzugt 6 bis 16 C-Atomen sein, in dem zwei Carboxylgruppen an zwei benachbarte C-Atome gebunden sind. Bevorzugt ist Trimellitsäure.

Die Polyamidimide können nur aus Diaminen der Formeln VI oder VIa und Tricarbonsäuren der Formel VII aufgebaut sein. Copolymere erhält man, wenn man zusätzlich Dicarbonsäuren und/oder Diamine, wie sie z.B. zuvor für die Polyamide erwähnt wurden, bei der Herstellung der Polyamidimide mitverwendet.

Polyesterimide sind erhältlich, wenn man zunächst eine Aminocarbonsäure bzw. einen Aminoalkohol mit Tricarbonsäuren der Formel VII zu Dicarbonsäuren bzw. Hydroxycarbonsäuren umsetzt, und diese darauf mit Diolen und/oder Dicarbonsäuren der Formeln VI und/oder VIa weiter zu Polyestern polykonden-

siert. Auch hier können zusätzlich weitere Dicarbonsäuren und/oder Diole zur Herstellung von Copolymeren verwendet werden.

Ferner sind auch Polyesteramide bevorzugt. Diese Polymeren erhält man, wenn Dicarbonsäuren der Formeln VI oder VIa und/oder weitere Dicarbonsäuren mit Diolen der Formeln VI oder VIa und/oder anderen Diolen und Diaminen der Formeln VI und/oder VIa und/oder anderen Diaminen polykondensiert werden, wobei die einzelnen Monomeren zuvor schon erwähnt wurden.

Die N-Atome der Amidgruppen in den zuvor genannten Polymeren können durch Alkyl mit vorzugsweise 1 bis 6 C-Atomen, Aryl wie z.B. Phenyl, Aralkyl wie z.B. Benzyl oder Cycloalkyl wie z.B. Cyclohexyl substituiert sein.

Weitere erfindungsgemässe Polymere sind zum Beispiel:

a) Polysiloxane aus Diolen der Formeln VI und/oder VIa und gegebenenfalls weiteren Diolen und Silanen der Formel $(R^{40})_2SiB_2$, worin $R^{40}$ bevorzugt Alkyl mit 1 bis 6 C-Atomen, besonders Methyl und Aryl, besonders Phenyl ist, und B für Br und besonders Cl oder Alkoxy sowie Aryloxy mit bevorzugt 1 bis 6 C-Atomen besonders Methoxy oder Phenoxy steht. Diese Polymere können somit Strukturelemente der Formel

$$\begin{array}{l} \;\;R^{40} \\ \;\;| \\ -Si-O-E-O- \\ \;\;| \\ \;\;R^{40} \end{array}$$

und gegebenenfalls der Formel

$$\begin{array}{l} \;\;R^{40} \\ \;\;| \\ -Si-O-E'-O \\ \;\;| \\ \;\;R^{40} \end{array}$$

enthalten, worin E dem Rest der Formeln I und/oder II entspricht, worin q = 1 ist, und E' der zweiwertige Rest eines Dioles ist. In Frage kommende Diole HOE'OH wurden schon zuvor erwähnt. Ferner können diese Polymeren zusätzliche Blöcke mit Strukturelementen der Formel

$$\begin{array}{l} \;\;R^{40} \\ \;\;| \\ -SiO- \\ \;\;| \\ \;\;R^{40} \end{array}$$

enthalten,

wobei diese Blöcke bis zu 50 Mol.-% ausmachen können, bezogen auf das Polymer.

b) Ungesättigte Polyester aus ungesättigten Dicarbonsäuren, besonders Maleinsäure und Diolen der Formeln I und/oder II (HOEOH) und gegebenenfalls weiteren Dicarbonsäuren, auch der Formeln I und/oder II und weiteren Diolen HOE'OH. Geeignete Dicarbonsäuren wurden bereits zuvor erwähnt. Diese Polymeren können somit Strukturelemente der Formel

$$\begin{array}{l} \;\;O\;\;\;\;\;\;\;\;O \\ \;\;\|\;\;\;\;\;\;\;\;\| \\ -C-E''-C-OEO- \end{array}$$

enthalten, worin E'' der zweiwertige Rest einer äthylenisch ungesättigten Dicarbonsäure ist. Als weitere

Strukturelemente können

$$-\overset{O}{\overset{\|}{C}}-E'''-\overset{O}{\overset{\|}{C}}-OEO-,\quad -\overset{O}{\overset{\|}{C}}-E'''-\overset{O}{\overset{\|}{C}}-OE'O-\quad \text{und}\quad -\overset{O}{\overset{\|}{C}}-E''-\overset{O}{\overset{\|}{C}}-OE'O-,$$

enthalten sein, worin E''' der zweiwertige Rest einer Dicarbonsäure der Formeln I und/oder II oder einer anderen Dicarbonsäure ist.

Diese Polymeren können zusätzlich thermisch in Gegenwart üblicher Polymerisationskatalysatoren durch die Anwesenheit der äthylenisch ungesättigten Gruppen polymerisiert werden, gegebenenfalls zusammen mit reaktiven Verdünnern wie Styrol.

c) Geeignete Epoxidharze sind auf verschiedene Weise erhältlich. So können die Epoxidverbindungen der Formeln VI oder VIa alleine oder zusammen mit weiteren Polyepoxidverbindungen mit mehr als einer Epoxidgruppe im Molekül katalytisch z.B. mit tertiären Aminen zu Poyäthern umgesetzt werden oder sie können mit üblichen Härtern wie Polyolen, bevorzugt Polyphenolen, Polycarbonsäuren und deren Anhydriden oder Polyaminen reagiert werden. Als Härter können auch die Diamine, Diole und Dicarbonsäuren der Formeln VI und VIa verwendet werden, wobei dann auch nur übliche Polyepoxidverbindungen eingesetzt werden können. Die Epoxidharze können als Präpolymere verwendet werden, die man nach der Bestrahlung thermisch aushärten kann.

d) Aromatische Polyäther sind z.B. durch die Umsetzung von Verbindungen der Formeln VI und/oder VIa, worin W = OH bzw. Halogen, besonders Br oder Cl ist, und R und R' ein aromatischer Rest bedeuten, mit phenylaromatischen Dichloriden oder Bromiden bzw. Diolen erhältlich. Geeignete Halogenide bzw. Diole sind z.B. ein- oder zweikernige phenylaromatische Derivate wie Hydrochinon, p-Dichlor- oder p-Dibromphenylen, p-Dihydroxyphenylen, p-Dichlor- oder p-Dibromdiphenylen, Bis(-p-Hydroxyphenyl)äther, Bis-(p-Chlorphenyl)äther. Die phenylaromatischen Reste könne weitere Substituenten wie z.B. Alkyl mit bevorzugt 1 bis 4 C-Atomen enthalten. Verwendet man zweikernige phenylaromatische Reste, bei denen die Phenylgruppen in eine Sulfongruppe gebunden sind, so erhält man Polyäthersulfone. Beispiele für solche Derivate sind Bis(p-Chlorphenyl)-sulfon und Bis(p-hydroxyphenyl)sulfon. Polyäther, die nur Strukturelemente der Formel I und/oder II enthalten, erhält man aus Verbindungen der Formel VI und/oder VIa, worin W = OH ist, mit Verbindungen der Formeln VI oder VIa, worin W = Halogen ist.

e) Aromatische Polyketone sind erhältlich durch die Umsetzung von aromatischen Verbindungen der Formeln VI und/oder VIa, worin W = H ist, mit aromatischen Säurehalogeniden der Formeln VI und/oder VIa, worin W = eine Säurehalogenidgruppe, besonders eine Säurechloridgruppe bedeutet, in Gegenwart von Lewis-Säuren. Zusätzlich können weitere aromatische, besonders phenylaromatische Verbindungen und/oder aromatische, besonders phenylaromatische Dicarbonsäuredihalogenide mitverwendet werden. Bei den aromatischen Verbindungen handelt es sich bevorzugt um ein- oder zweikernige Phenylaromaten bzw. um ihre Dicarbonsäuredihalogenidderivate. Beispiele sind Benzol, Toluol, Diphenyl, Diphenylmethan, Diphenylketon, Diphenylsulfon, Diphenläther, Terephthalsäuredichlorid, 4,4'-Chlorcarbonyldiphenyl, -diphenylmethan, -diphenyläther oder -diphenylsulfon. Bei Verwendung der Aetherderivate erhält man Polyätherketone. Die aromatischen Kohlenwasserstoffe bzw. Dicarbonsäuredihalogenide können substituiert sein, z.B. mit Alkyl mit 1 bis 4 C-Atomen.

f) Aromatische Polythioäther sind z.B. erhältlich durch die Umsetzung von aromatischen Verbindungen der Formeln VI und/oder VIa worin W = Halogen wie Cl und besonders Br ist, mit Dialkalisulfiden, z.B. $Na_2S$. Es können auch andere aromatische, besonders phenylaromatische Dihalogenverbindungen, bevorzugt Chloride und besonders Bromide mitverwendet werden. Aromatische Polysulfide sind auch erhältlich durch die Umsetzung von aromatischen Verbindungen der Formeln VI und/oder VIa, worin W = SH ist, alleine oder zusammen mit anderen besonders phenylaromatischen Dimerkaptanen, bzw. besonders deren Alkalisalzen wie z.B. der Natriumsalze, mit Verbindungen der Formeln VI und/oder VIa, worin W für Halo-Halogen, besonders Br steht, und/oder anderen besonders phenylaromatischen Dihalogeniden, wie z.B. Bromiden. Solche Halogenide wurden schon zuvor erwähnt. Geeignete aromatische Dimercaptane sind z.B. 1,4-Phenylendimerkaptan oder p-Biphenylendimerkaptan.

g) Weitere geeignete Polymere sind z.B. solche, die durch die Umsetzung von Verbindungen der Formeln VI und/oder VIa, worin W für OH, $NH_2$ oder COOH steht, mit Diisocyanaten oder Diepoxyden erhältlich sind.

h) Eine weitere Gruppe geeigneter Polymerer sind aromatische Polyimidazole. Sie sind erhältlich durch Umsetzung von Estern der Formeln VI und/oder VIa alleine oder zusammen mit weiteren aromatischen

Dicarbonsäurediestern und aromatischen Tetraminen, z.B. 3,3' ,4,4'-Tetraaminobiphenyl, zu Polyamidvorstufen, die dann durch Erhitzen zu den Polyimidazolen kondensiert werden.

Die erfindungsgemässen Polymeren sind in unterschiedlichen Lösungsmitteln löslich, gegebenenfalls unter Erwärmen,und die erfindungsgemässen Polyimide weisen erhöhte Glasumwandlungstemperaturen auf, die bis zu 400 °C betragen können. Sie eignen sich hervorragend zur Herstellung von Filmen und Shutzüberzügen, wobei Beschichtungsmittel aus einer Lösung der Polymeren, bevorzugt der Polyimide in einem Lösungsmittel Anwendung finden können. Ein weiterer Gegenstand vorliegender Erfindung ist ein solches Beschichtungsmittel, ein hiermit beschichtetes Material und die Verwendung der erfindungsgemässen Polymere zur Herstellung von Schutzüberzügen. Beschichtungsmittel und beschichtetes Material umfassen auch die zuvor definierten Polyimide mit q = O und R gleich aliphatischem, cycloaliphatischen, araliphatischen, verknüpften aromatischen und mono- oder polysubstituierten aromatischen Resten.

Zur Herstellung des erfindungsgemässen beschichteten Materials löst man das Polymer oder Gemische davon zweckmässig in einem geeigneten organischen Lösungmittel, gegebenenfalls unter Erwärmung. Geeignete Lösungsmittel sind z.B. polare, aprotische Lösungsmittel, die alleine oder in Mischungen aus mindestens zwei Lösungsmitteln verwendet werden können. Beispiele sind: Aether wie Dibutyläther, Tetrahydrofuran, Dioxan, Methylenglykol, Dimethyläthylenglykol, Dimethyldiäthylenglykol, Diäthyldiäthylenglykol, Dimethyltriäthylenglykol, halogenierte Kohlenwasserstoffe wie Methylenchlorid, Chloroform, 1,2-Dichloräthan, 1,1,1-Trichloräthan, 1,1,2,2-Tetrachloräthan, Carbonsäureester und Lactone wie Essigäureäthylester, Propionsäuremethylester, Benzoesäureäthylester, 2-Methoxyäthylacetat, γ-Butyrolacton, δ-Valerolacton und Pivalolacton, Carbonsäureamide und Lactame wie Formamid, Acetamid, N-Methylformamid, N,N-Dimethylformamid, N,N-Diäthylformamid, N,N-Dimethylacetamid, N,N-Diäthylacetamid, γ-Butyrolactam, ε-Caprolactam, N-Methypyrrolidon, N-Acetylpyrrolidon, N-Methylacaprolactam, Tetramethylharnstoff, Hexamethylphosphorsäureamid, Sulfoxide wie Dimethylsulfoxid, Sulfone wie Dimethylsulfon, Diäthylsulfon, Trimethylensulfon, Tetramethylensulfon, Trimethylamin, Triäthylamin, N-Methylpyrrolidin, N-Methylpiperidin, N-Methylmorpholin, substituierte Benzole wie Chlorbenzol, Nitrobenzol, Phenole oder Kresole.

Ungelöste Anteile können durch Filtration, bevorzugt einer Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weitere übliche Zusatzstoffe einveileibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente Haftvermittler und Antihalofarbstoffe, wie sie z.B. in der US-PS 4 349 619 beschrieben sind.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca 500 µm und mehr, bevorzugt von 0,5 bis 500 µm und besonders von 1 bis 50 µm aufweisen.

Es wurde gefunden, dass die erfindungsgemässen Polymere autophotovernetzbar sind und unter Strahlungseinwirkung vernetzt werden können.

Da die Lichtempfindlichkeit mit steigendem Gehalt an solchen Strukturelementen steigt, ist ein Gehalt von mindestens 50 Mol-%, bevorzugt mindestens 60 Mol-% und besonders mindestens 90 Mol-% vorteilhaft. Die Lichtempfindlichkeit hängt auch vom Molekulargewicht des Polymeren ab.

Schutzfilme aus solchen Polymeren können durch Strahlungseinwirkung weiter modifiziert werden, womit z.B. erhöhte Thermostabilitäten möglich sind. Ferner besteht die Möglichkeit, solche Polymere als photographisches Aufzeichnungsmaterial für Reliefabbildungen einzusetzen. Durch die Direktvernetzung unter Strahlungseinwirkung können Zusätze wie Sensibilisatoren vermieden werden und die Schutzschichten und Abbildungen weisen ausgezeichnete elektrische Eigenschaften auf. Weiter zeichnen sich die Schutzschichten und Abbildungen durch ihre hohe Thermostabilität aus sowie durch keinen oder nur einen geringen Schwund bei thermischer Belastung, was in der Anwendung erhebliche Vorteile hat, weil praktisch keine Verzerrung abgebildeter Strukturen beobachtet wird. Die Schichtdicke beträgt für diese Anwendung bevorzugt 0,5 bis 100 µm, besonders 1 bis 50 µm und insbesondere 1-10 µm.

Die Photostrukturierung bzw. Photovernetzung kann durch energiereiche Strahlung hervorgerufen werden, z.B. durch Licht insbesondere im UV-Bereich,durch Röntgenstrahlen, Laserlicht, Elektronenstrahlen

usw. Das erfindungsgemässe Material eignet sich hervorragend zur Herstellung von Schutzfilmen, Passivierlacken, und als photographisches Aufzeichnungsmaterial für thermostabile Reliefabbildungen.

Anwendungsgebiete sind z.B. Schutz-, Isolier- und Passivierlacke in der Elektrotechnik und Elektronik, Photomasken für die Elektronik, den Textildruck und das graphische Gewerbe, Aetzresist zur Herstellung gedruckter Schaltungen und Druckplatten und integrierter Schaltkreise, Relais für die Herstellung von Röntgenmasken, als Löststopplack, als Dielektrikum für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten

Die photographische Erzeugung der Reliefstruktur erfolgt durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Ein weiterer Gegenstand der Erfindung ist ein solches Verfahren zum Aufbringen von Reliefstrukturen. Als Entwickler sind z.B` die zuvor erwähnten Lösungsmittel geeignet.

Die Polymerschicht des erfindungsgemässen Materials weist eine für viele Anwendunszwecke ausreichende und teilweise hohe Lichtempfindlichkeit auf und sie kann direkt photovernetzt werden. Die Schutzfilme und Reliefabbildungen zeichnen sich durch hohe Haftfestigkeit und thermische, mechanische und chemische Widerstandsfähigkeit aus. Bei thermischen Nachbehandlungen wird nur ein geringer Schwund beobachtet. Ferner können Zusätze zur Erzeugung bzw. Steigerung der Lichtempfindlichkeit vermieden werden. Das Material ist lagerstabil, aber vorteilhaft vor Lichteinwirkung zu schützen.

Die nachfolgenden Beispiele erläutern die Erfindung näher. Die Viskosität wird in einer Lösung von 0,5 g Polymer in 100 ml N-Methylpyrrolidon bei 25 °C bestimmt. Die Glasumwandlungstemperatur wird durch Differential-Scanning-Calometril (DSC) ermittelt.

Die in den Beispielen verwendeten Dianhydride haben die Strukturen A bis D:

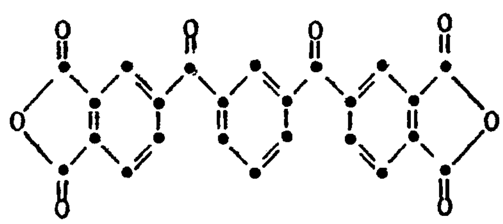

A

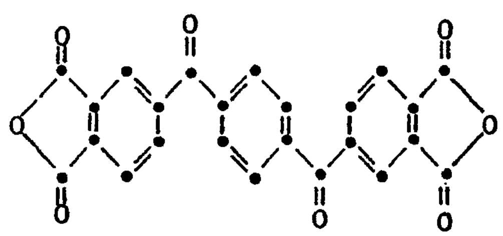

B

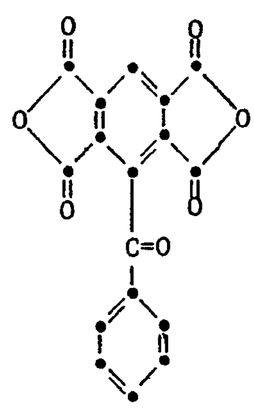

C

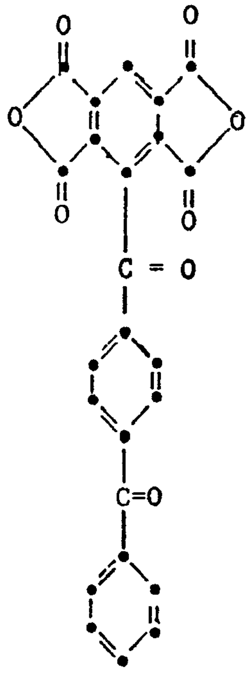

D

Die Herstellung von A und B ist in der französischen Patentschrift 1,601,094 beschrieben. Die Herstellung von C ist in der US-Patent-schrift 3,299.101 beschrieben. D wird analog zu C hergestellt.

A) Herstellungsbeispiele

Beispiel 1

In einem zylindrischen Gefäss, das mit Rührer, Tropftrichter, Innenthermometer und Gaseinleitungsrohr sowie Gasableitungsrohr ausgestattet ist, werden 1,642 g (0,01 Mol) 3,6-Diaminodurol unter Stickstoff in 25 ml N-Methylpyrrolidon (NMP) gelöst und die Lösung auf 5 bis 0° C abgekühlt. Dann werden 4,263 g Dianhydrid der Formel A zugegeben und eine Stunde lang gerührt. Im Verlaufe einer weiteren Stunde werden noch 2 Portionen Dianhydrid zu je 0,0426 g Dianhydrid zugesetzt.

Nach 3 Stunden werden 3,1 ml Triäthylamin und 8,5 ml Acetanhydrid zugegeben und 16 Stunden bei Raumtemperatur gerührt, wobei die Polyamidsäure zum Polyimid cyclisiert wird.

Die Isolierung des Polyimids erfolgt durch Ausfällen mit 1 Liter Wasser. Das Polymer wird filtriert, erneut mit 1 Liter Wasser behandelt, wieder filtriert und bei 80° C im Vakuum getrocknet. Die Eigenschaften des Polyimids sind in Tabelle 1 zusammengefasst.

Beispiele 2 bis 20

Analog Beispiel 1 werden verschiedene Diamine oder Diaminmischungen mit Dianhydriden der Formeln A, B, C oder D in NMP umgesetzt umgesetzt und zu den entsprechenden Polyimiden cyclisiert.

Die Zusammensetzung und die Eigenschaften sind in Tabelle 1 zusammengefasst:

Tabelle 1

| Beispiel | Dianhydrid | Diamin | η inh (dl/g) | Tg (°C) |
|---|---|---|---|---|
| 1 | A | 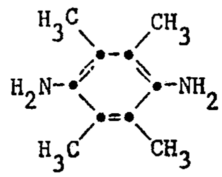 | 0,543 | 336 |
| 2 | A | 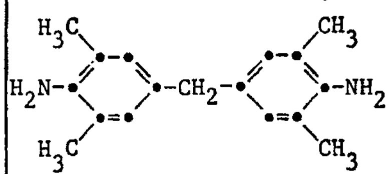 | 0,515 | 290 |
| 3 | A | 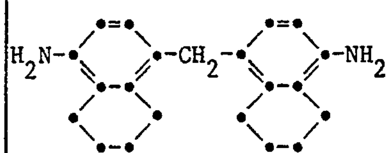 | 0,568 | 292 |
| 4 | A | 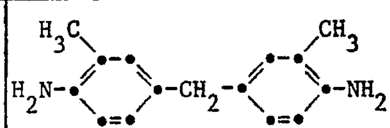 | 0,571 | 258 |
| 5 | A | $H_2N-(CH_2)_{10}-NH_2$ | 0,166 | 112 |
| 6 | A | 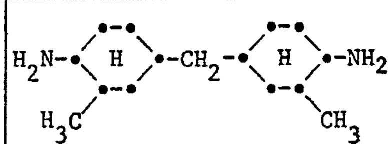 | 0,428 | 255 |
| 7 | A | 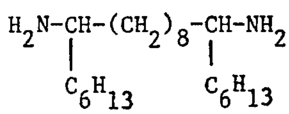 | 0,346 | 82 |
| 8 | A | 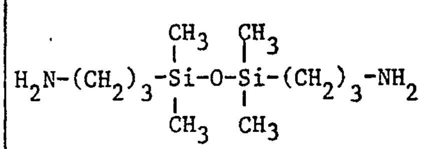 | 0,218 | 90 |

Tabelle 1 (Fortsetzung)

| Beispiel | Dianhydrid | Diamin | $\eta$ inh (dl/g) | Tg (°C) |
|---|---|---|---|---|
| 9 | A | 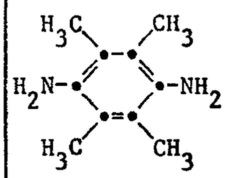 70 Mol-% 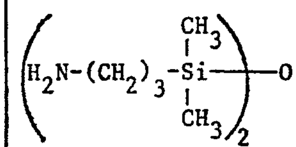 30 Mol-% | 0,310 | 252 |
| 10 | A | 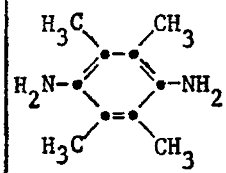 87.1 Mol-% 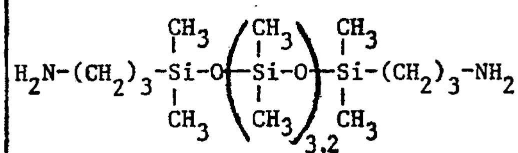 12.9 Mol-% | 0,234 | 326 |
| 11 | A | 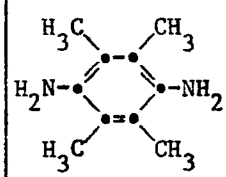 70 Mol-% 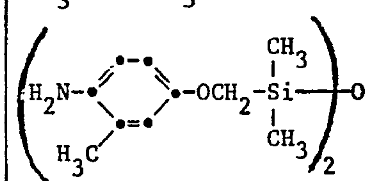 30 Mol-% | 0,26 | 244 |
| 12 | A | 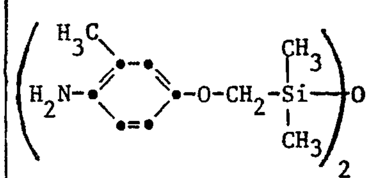 | 0,17 | 142 |
| 13 | B | 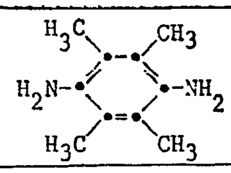 | 0,52 | 384 |

Tabelle 1 (Fortsetzung)

| Beispiel | Dianhydrid | Diamin | $\eta$inh (dL/g) | Tg (°C) |
|---|---|---|---|---|
| 14 | B | 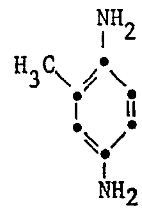 | 0,33 | 263 |
| 15 | B | 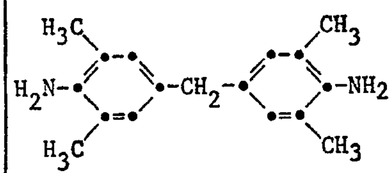 50 Mol-% 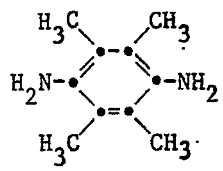 25 Mol-% 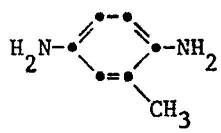 25 Mol-% | 0,47 | 289 |
| 16 | C | 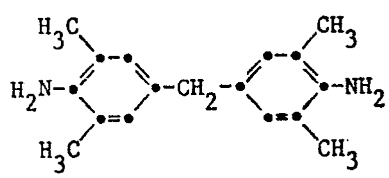 | 0,306 | 333 |
| 17 | C | 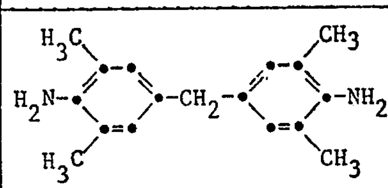 50 Mol-% 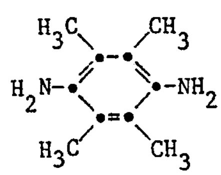 50 Mol-% | 0,393 | 321 |
| 18 | C | 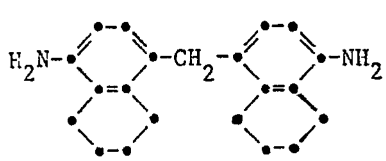 | 0,528 | 360 |

Tabelle 1 (Fortsetzung)

| Beispiel | Dianhydrid | Diamin | η inh (dl/g) | Tg (°C) |
|---|---|---|---|---|
| 19 | C | 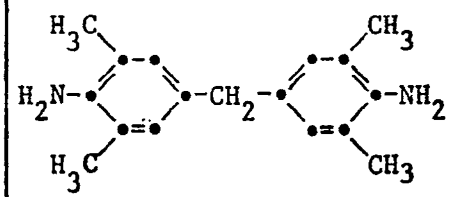 50 Mol-% <br> 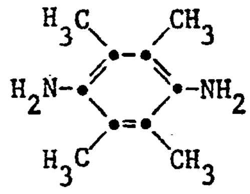 25 Mol-% <br> 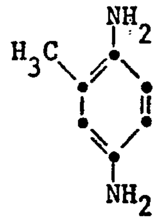 25 Mol-% | 0,372 | 371 |
| 20 | D | 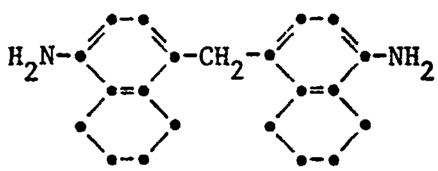 | 0,322 | 377 |

B) Anwendungsbeispiele

Auf einer einseitig Kupfer-kaschierten Kunststoffplatte wird ein dünner Polymerfilm erzeugt, indem eine 5 %ige Polymerlösung aufgeschleudert wird und das Lösungsmittel anschliessend in einem Umluftofen entfernt wird. Als Lösungsmittel wird N-Methylpyrrolidon verwendet.

Die so beschichteten Platten werden durch eine Photomaske (Stouffer-Keil) bei Raumtemperatur mit einer 1000 Watt-UV-Lampe aus 18 cm Entfernung belichtet. Die belichteten Platten werden anschliessend mit einem Lösungsmittel entwickelt, wobei die unbelichteten Anteile des Polymerfilms weggelöst werden. Die Sichtbarmachung des Reliefbildes geschieht anschliessend durch Wegätzen der freigelegten Kupferschicht mit $FeCl_3$-Lösung.

Die Belichtungszeit, der verwendete Entwickler und die Photoempfindlichkeit (21-step Stouffer sensitivity guide) sind in der folgenden Tabelle zusammengefasst.

Tabelle

| Polymer gemäss Beispiel | Belichtungszeit (Sekunden) | Entwickler | Empfindlichkeit (Stouffer Skala) |
|---|---|---|---|
| 1 | 60 | NMP | 8 |
| 2 | 20 | NMP | 6 |
| 3 | 90 | NMP | 7 |
| 4 | 120 | NMP | 6 |
| 5 | 500 | m-Kresol | 3 |
| 7 | 400 | m-Kresol | 4 |
| 8 | 500 | Xylol/$CHCl_3$ | 2 |
| 9 | 180 | NMP | 6 |
| 10 | 300 | NMP | 5 |
| 11 | 600 | NMP | 2 |
| 12 | 600 | NMP | 2 |
| 14 | 180 | NMP | 6 |
| 15 | 60 | NMP | 9 |
| 16 | 240 | $CHCl_3$ | 6 |
| 17 | 180 | $CHCl_3$ | 5 |
| 18 | 900 | NMP/$CHCl_3$ | 2 |
| 19 | 240 | Cyclohexanon | 5 |
| 20 | 240 | NMP/$CHCl_3$ | 4 |

## Patentansprüche

1. Verfahren zur Herstellung vernetzter Polymerer, dadurch gekennzeichnet, dass man ein Homo- oder Copolymeres, das ein mittleres Molekulargewicht von mindestens 2000 aufweist und das mindestens 5 Mol%, bezogen auf das Polymer, mindestens eines Strukturelementes der Formel I und/oder II enthält

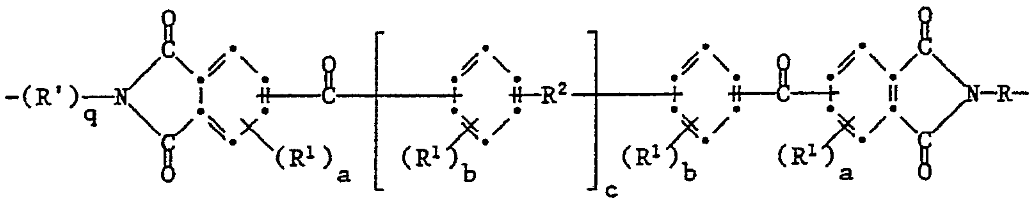

(I)

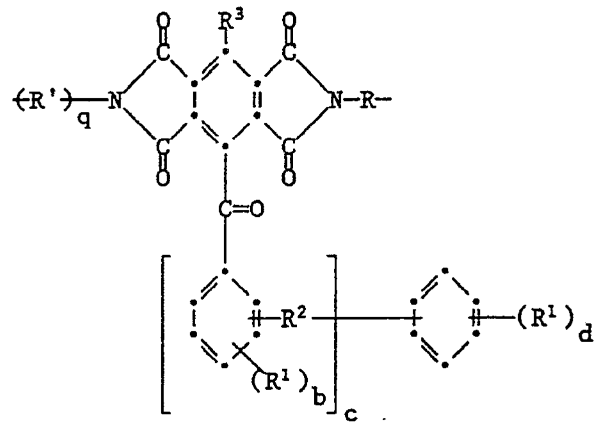

(II),

worin

$R^1$ für Halogen, Nitro, $C_1$-$C_6$-Alkyl, $C_1$-$C_6$-Alkoxy, $C_1$-$C_6$-Alkylthio, das durch Phenyl substituiert sein kann, Phenyl, Phenoxy oder Phenylthio steht,

$R^2$ eine direkte Bindung oder eine Brückengruppe bedeutet

$R^3$ für ein Wasserstoffatom oder Aryl steht oder die gleiche Bedeutung wie $R^1$ hat,

a für 0, 1, 2 oder 3, b für 0, 1, 2, 3 oder 4, c und d für 0, 1, 2, 3, 4 oder 5 stehen, q für 0 oder 1 steht, und falls

a, b und d 2 sind, auch beide $R^1$ in o-Stellung gebunden sein und zusammen -CH=CH-CH=CH- bedeuten können, und

R und R' ein unsubstituierter oder substituierter zweiwertiger aliphatischer Rest, der durch Heteroatome, aromatische, heterocyclische oder cycloaliphatische Gruppen unterbrochen sein kann, ein unsubstituierter oder substituierter cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxygruppe, Alkoxyalkylgruppe, Alkylthiogruppe, Alkylthioalkylgruppe oder Aralkylgruppe substituierter aromatischer Rest oder an zwei benachbarten C-Atomen des aromatischen Restes durch eine Alkylengruppe substituierter aromatischer Rest sind, wobei R ein aromatischer Rest ist, der in beiden Orthostellungen mindestens eines N-Atoms substituiert ist, wenn q = 0 ist, mit energiereicher Strahlung bestrahlt.

2. Verfahren gemäss Anspruch 1 zur Herstellung von Reliefabbildungen auf einem Träger umfassend das bildmässige Bestrahlen eines mit einem Polymeren beschichteten Trägermaterials durch eine Photomaske mit energiereicher Strahlung und das Entfernen der unbelichteten Anteile mit einem Entwickler, dadurch gekennzeichnet, dass man ein Homo- oder Copolymer gemäss Anspruch 1 verwendet.

3. Verfahren gemäss Anspruch 1 zur Herstellung von Schutzschichten auf einem Träger umfassend das flächenmässige Bestrahlen eines mit einem Polymeren beschichteten Trägermaterials mit energiereicher Strahlung, dadurch gekennzeichnet, dass man ein Homo- oder Copolymer gemäss Anspruch 1 verwendet.

4. Verfahren gemäss einem der Ansprüche 1 bis 3, dadurch gekennzeichnet, dass die Strukturelemente den Formeln Ia oder IIa entsprechen

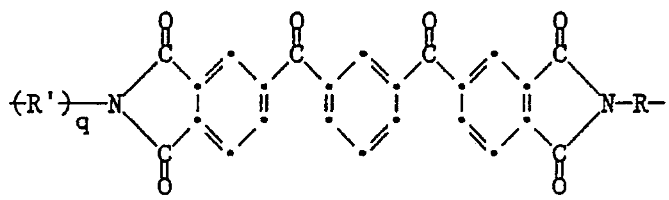

(Ia)

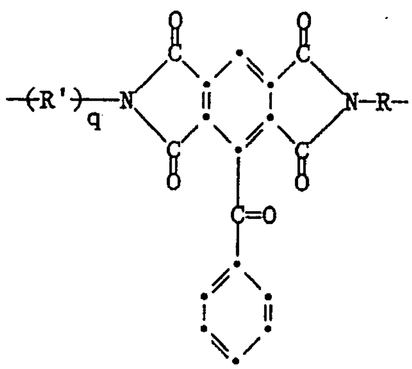

(IIa),

worin q, R und R' die in Anspruch 1 angegebene Bedeutung haben.

5. Verfahren gemäss einem der Ansprüche 1 bis 3, dadurch gekennzeichnet, dass der Substituent des aromatischen Restes R oder R' Alkyl, Alkoxy oder Alkoxyalkyl mit 1 bis 6 C-Atomen, Benzyl oder Trimethylen oder Tetramethylen ist.

6. Verfahren gemäss einem der Ansprüche 1 bis 3, dadurch gekennzeichnet, dass ein oder zwei Substituenten im aromatischen Rest R oder R' in Orthostellung zum N-Atom gebunden sind.

7. Verfahren gemäss einem der Ansprüche 1 bis 3, dadurch gekennzeichnet, dass R als aliphatischer Rest 2 bis 30 C-Atome, als cycloaliphatischer Rest 5 bis 8 Ring-C-Atome, als araliphatischer Rest 7 bis 30 C-Atome, als aromatischer Rest mit über eine aliphatische Gruppe verknüpften Arylkernen 13 bis 30 C-Atome und als substituierter aromatischer Rest 7 bis 30 C-Atome enthält.

8. Verfahren gemäss einem der Ansprüche 1 bis 3, dadurch gekennzeichnet, dass es sich bei dem Polymeren um ein in organischen Lösungsmitteln lösliches Homo- oder Copolyimid mit 5 bis 100 Mol-% Strukturelementen der Formeln I und/oder II handelt, worin q = O ist, und R ein aromatischer Rest ist, der in beiden Orthostellungen mindestens eines N-Atomes durch Alkyl, Cycloalkyl, Alkoxy, Alkoxyalkyl, Alkylthio, Alkylthioalkyl, Aralkyl oder zwei benachbarte C-Atome des aromatischen Restes durch Alkylen substituiert sind, und 0 bis 95 Mol-% Strukturelementen der Formel III

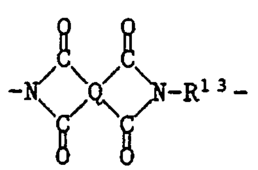

(III)

worin Q ein vierwertiger organischer Rest und $R^{13}$ ein zweiwertiger organischer Rest sind und $R^{13}$ die Bedeutung von R hat.

9. Verfahren gemäss Anspruch 8, dadurch gekennzeichnet, dass Q

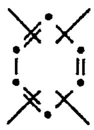 , 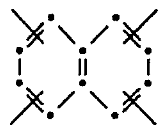 ,

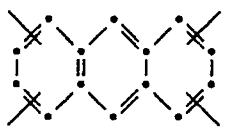 , 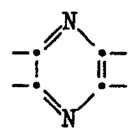 , 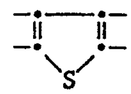

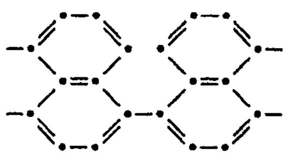 , 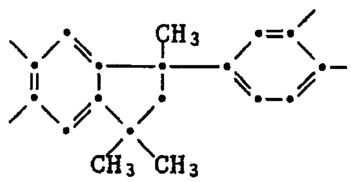

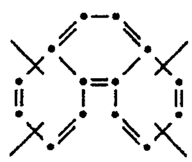 , 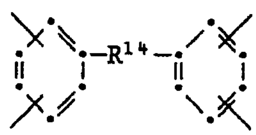

sind,
worin $R^{14}$ eine direkte Bindung oder eine Brückengruppe der Formeln

-O-, -S-, $-SO_2-$, 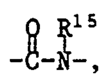, 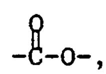, 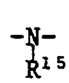 , 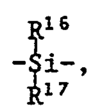,

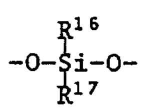, 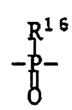 , 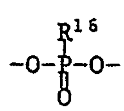 , -N=N-, 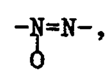, 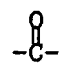 ,

-NH-, 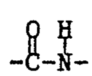, $-CH_2-$, $-CH_2CH_2-$, 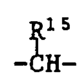, 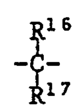

sind, worin $R^{15}$, $R^{16}$ und $R^{17}$ Alkyl mit 1 bis 6 C-Atomen, Phenyl oder Benzyl und $R^{16}$ und $R^{17}$ auch Alkoxy mit 1 bis 6 C-Atomen, Phenyloxy oder Benzyloxy sind.

**10.** Verfahren gemäss Anspruch 9, dadurch gekennzeichnet, dass R in Formeln I und II Resten der Formeln

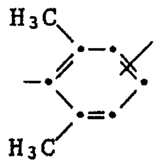, 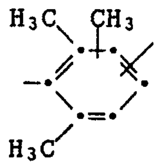, 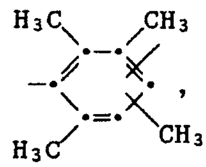, 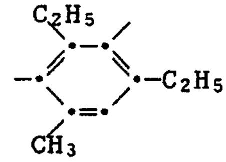

entsprechen, worin die freien Bindungen in Meta- oder Parastellung zueinander stehen, oder der Formel

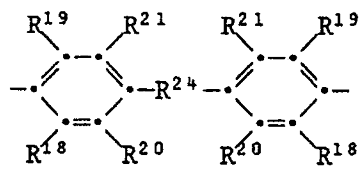

entsprechen, worin $R^{18}$ und $R^{19}$ unabhängig Methyl, Aethyl, n-Propyl oder Isopropyl und $R^{20}$ und $R^{21}$ ein Wasserstoffatom sind oder die Bedeutung von $R^{19}$ haben oder $R^{18}$ und $R^{20}$ zusammen Tri- oder Tetramethylen bedeuten und $R^{19}$ und $R^{21}$ ein Wasserstoffatom sind, und $R^{24}$ eine direkte Bindung, $CH_2$, 2,2-Propyliden oder CO ist.

**11.** Verfahren gemäss Anspruch 9, dadurch gekennzeichnet, dass man Polyimide aus wiederkehrenden Strukturelementen der Formeln

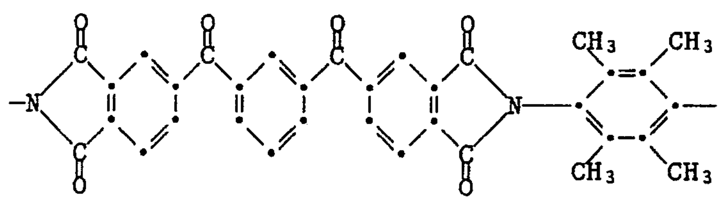

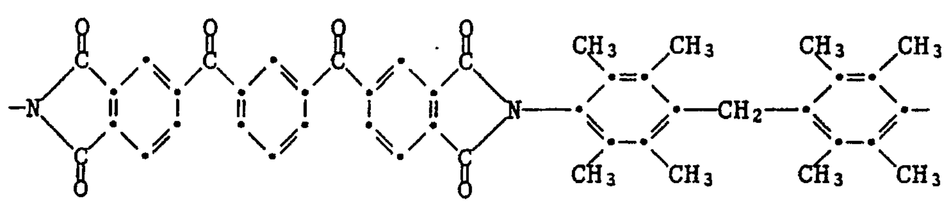 .

oder Mischungen dieser Strukturelemente verwendet.

**12.** Homo- oder Copolyimid mit einem mittleren Molekulargewicht von mindestens 2000, das mindestens 5 Mol%, bezogen auf das Polyimid, mindestens eines Strukturelementes der Formeln Ib oder IIb enthält.

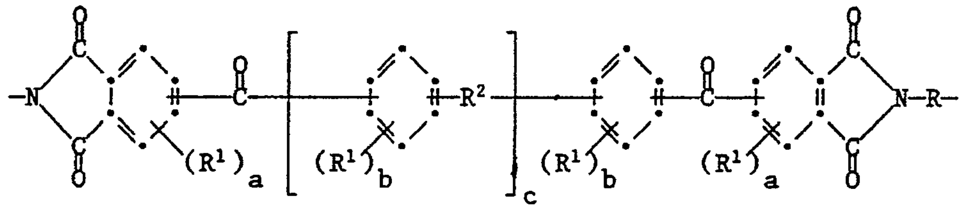

(Ib),

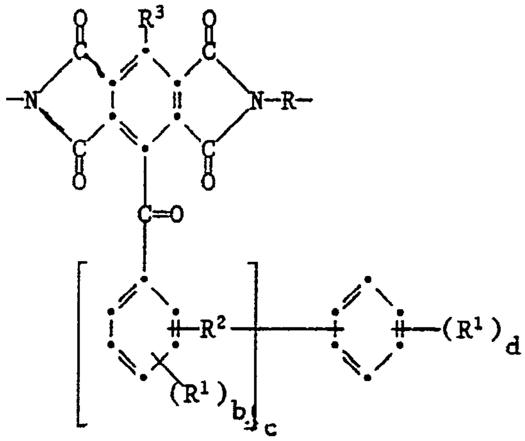

(IIb),

worin $R^1$, $R^2$, $R^3$, a, b, c und d die in Anspruch 1 definierte Bedeutung besitzen und R ein aromatischer Rest ist, der in beiden Orthostellungen mindestens eines N-Atoms durch Alkyl, Cycloalkyl, Alkoxy, Alkoxyalkyl, Alkylthio, Alkylthioalkyl oder Aralkyl substituiert ist oder worin zwei benachbarte C-Atome des aromatischen Restes durch Alkylen substituiert sind.

**13.** Copolymer mit einem mittleren Molekulargewicht von mindestens 2000, das ausgewählt ist aus der Gruppe der Polyamide, gesättigten Polyester, Polycarbonate, Polyamidimide, Polyesterimide, Polyesteramide, Polysiloxane, ungesättigten Polyester, Epoxidharze, der aromatischen Polyäther, der aromatischen Polyätherketone, der aromatischen Polyäthersulfone, der aromatischen Polyketone, der aromatischen Polythioäther oder Gemischen dieser Polymeren, dadurch gekennzeichnet, dass das Copolymer mindestens 5 Mol %, bezogen auf das Copolymer, mindestens eines Strukturelementes der Formeln I oder II gemäss Anspruch 1 enthält, worin q = 1 ist.

**14.** Polyimid gemäss Anspruch 12, dadurch gekennzeichnet, dass R ein Rest gemäss Anspruch 5 ist.

**15.** Polyimid gemäss Anspruch 12, dadurch gekennzeichnet, dass es sich um eine Verbindung gemäss einem der Ansprüche 8 bis 11 handelt.

**16.** Verwendung der Verbindungen gemäss Anspruch 12 oder 13 zur Herstellung von Schutzfilmen, Passivierlacken und als photographisches Aufzeichnungsmaterial für thermostabile Reliefabbildungen.

## Claims

**1.** A process for the preparation of a crosslinked polymer, which comprises irradiating, using high-energy radiation, a homopolymer or copolymer which has an average molecular weight of at least 2000 and which contains at least 5 mole%, relative to the polymer- of at least one structural element of the formula I and/or II

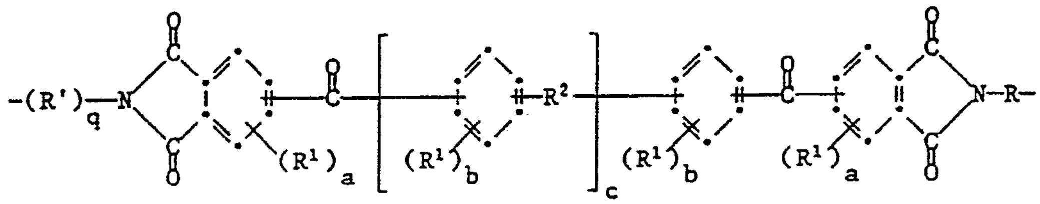

(I)

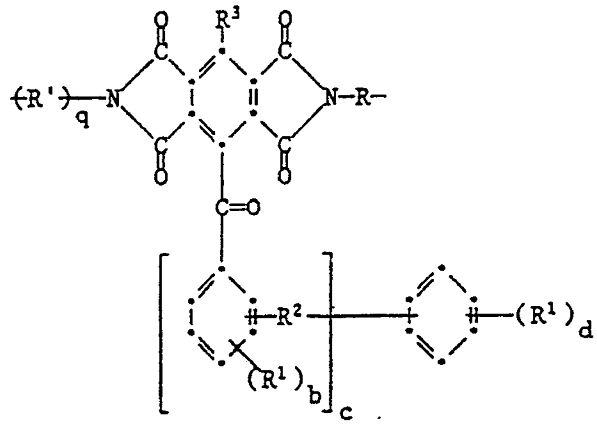

(II),

in which $R^1$ is halogen- nitro $C_1$-$C_6$-alkyl, $C_1$-$C_6$-alkoxy or $C_1$-$C_6$-alkylthio, each of which can be substituted by phenyl- or is phenyl, phenoxy or phenylthio, $R^2$ is a direct bond or a bridge group, $R^3$ is a hydrogen atom or aryl or is as defined for R', a is 0, 1, 2 or 3, b is 0, 1, 2, 3 or 4, c and d are 0, 1, 2, 3, 4 or 5 and q is 0 or 1, and if a, b and d are 2, the two $R^1$s are also attached in the o-position and together may be -CH=CH=CH=CH-, and R and R' are an unsubstituted or substituted divalent aliphatic radical which can be interrupted by hetero-atoms or by aromatic, heterocyclic or cycloaliphatic groups, or are an unsubstituted or substituted cycloaliphatic or araliphatic radical, an aromatic radical in which two aryl nuclei are linked via an aliphatic group, or an aromatic radical which is substituted by at least one alkyl group, cycloalkyl group, alkoxy group, alkoxyalkyl group, alkylthio group, alkylthioalkyl group or aralkyl group or which on two adjacent C atoms of the aromatic radical is substituted by an alkylene group, R being an aromatic radical which is substituted in the two ortho-positions relative to at least one N atom, if q is 0.

**2.** A process according to claim 1 for the production of relief images on a substrate, comprising the imagewise irradiation of a polymer-coated substrate material through a photomask using high-energy radiation and the removal of the unexposed areas using a developer, wherein a homopolymer or copolymer according to claim 1 is used.

**3.** A process according to claim 1 for the production of protective layers on a substrate, comprising the irradiation of the entire surface of a polymer-coated substrate material using high-energy radiation, wherein a homopolymer or copolymer according to claim 1 is used.

**4.** A process according to any one of claims 1 to 3, wherein the structural elements have the formula Ia or IIa

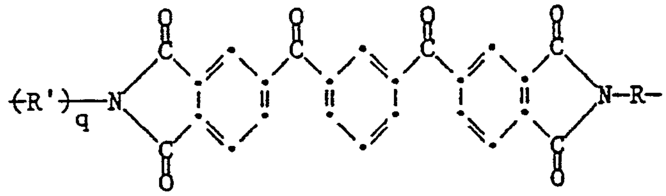

(Ia)

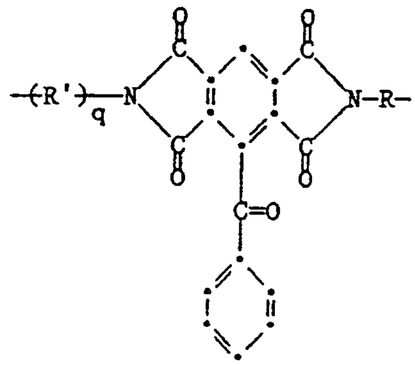

(IIa),

in which q, R and R' are as defined in claim 1.

5. A process according to any one of claims 1 to 3, wherein the substituent of the aromatic radical R or R' is alkyl, alkoxy or alkoxyalkyl having 1 to 6 C atoms, benzyl, trimethylene or tetramethylene.

6. A process according to any one of claims 1 to 3, wherein one or two substituents in the aromatic radical R or R' are attached in the orthoposition relative to the N atom.

7. A process according to any one of claims 1 to 3, wherein R as an aliphatic radical contains 2 to 30 C atoms, as a cycloaliphatic radical contains 5 to 8 ring C atoms, as an araliphatic radical contains 7 to 30 C atoms, as an aromatic radical having aryl rings linked via an aliphatic group contains 13 to 30 C atoms and as a substituted aromatic radical contains 7 to 30 C atoms.

8. A process according to any one of claims 1 to 3, wherein the polymer is a homopolyimide or copolyimide soluble in organic solvents and containing 5 to 100 mole% of structural elements of the formulae I and/or II in which q is O and R is an aromatic radical which is substituted in the two ortho-positions relative to at least one N atom by alkyl, cycloalkyl, alkoxy, alkoxyalkyl, alkylthio, alkylthioalkyl or aralkyl, or two adjacent C atoms of the aromatic radical are substituted by alkylene, and containing 0 to 95 mole% of structural elements of the formula III

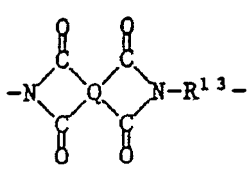

(III)

in which Q is a tetravalent organic radical and $R^{13}$ is a divalent organic radical and $R^{13}$ is as defined for R.

9. A process according to claim 8, wherein Q is

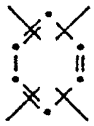 , 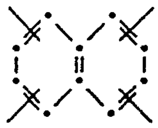 ,

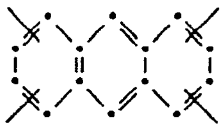 , 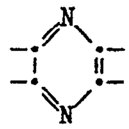 , 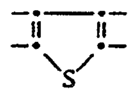

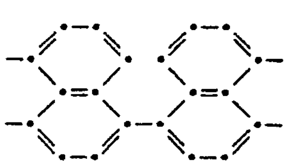 , 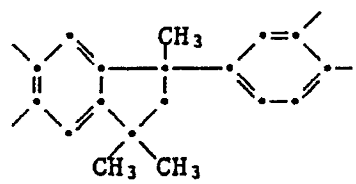

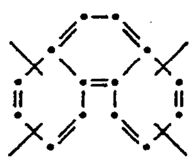 , 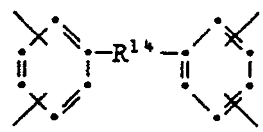

in which $R^{14}$ is a direct bond or a bridge group of the formulae

-O-, -S-, $-SO_2-$, 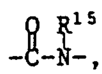, 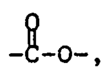, 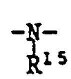 , 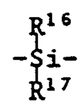,

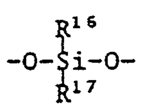, 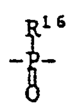 , 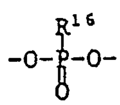 , -N=N-, 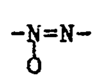, 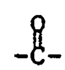 ,

-NH-, 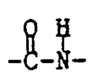, $-CH_2-$, $-CH_2CH_2-$, 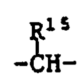, 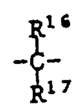

in which $R^{15}$, $R^{16}$ and $R^{17}$ are alkyl having 1 to 6 C atoms, phenyl or benzyl, and R16 and $R^{17}$ are also alkoxy having 1 to 6 C atoms, phenyloxy or benzyloxy.

**10.** A process according to claim 9, wherein R in formulae I and II is a radical of the formulae

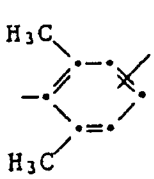 , 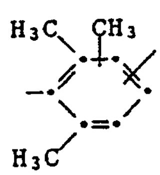 , 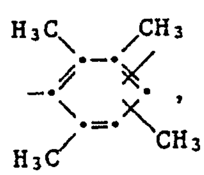 , 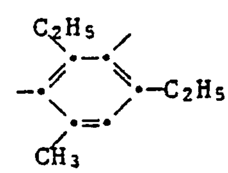

in which the free bonds are in the meta-position or para-position relative to one another, or of the formula

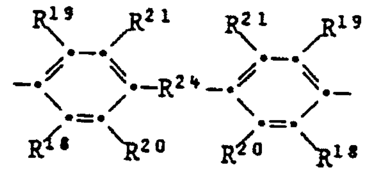

in which $R^{18}$ and $R^{19}$ independently are methyl, ethyl, n-propyl or isopropyl and $R^{20}$ and $R^{21}$ are a hydrogen atom or are as defined for $R^{19}$, or $R^{18}$ and $R^{20}$ together are trimethylene or tetramethylene, and $R^{19}$ and $R^{21}$ are a hydrogen atom and $R^{24}$ is a direct bond, $CH_2$, 2,2-propylidene or CO.

**11.** A process according to claim 9, which comprises using a polyimide which consists of recurring structural elements of the formulae

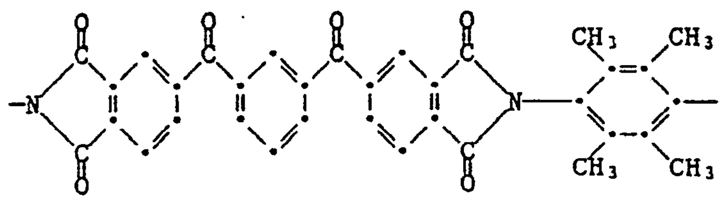

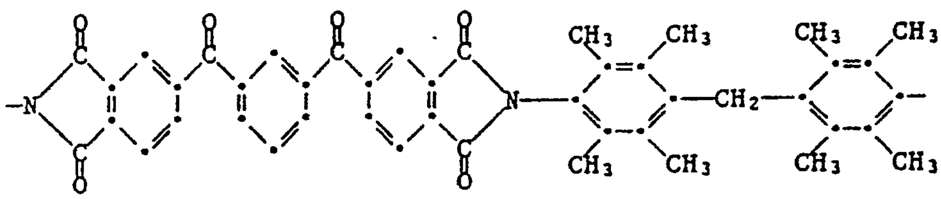

or mixtures of these structural elements.

**12.** A homopolyimide or copolyimide which has an average molecular weight of at least 2000 and which contains at least 5 mole%, relative to the polyimide, of at least one structural element of the formula Ib or IIb

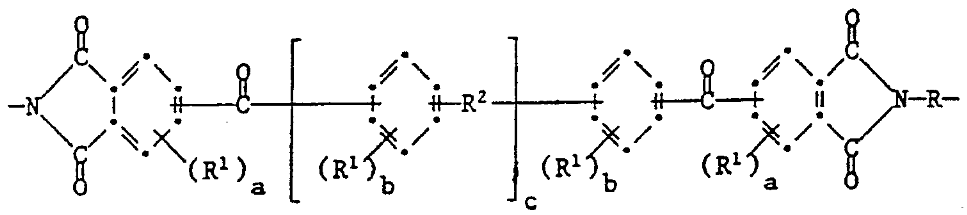

(Ib),

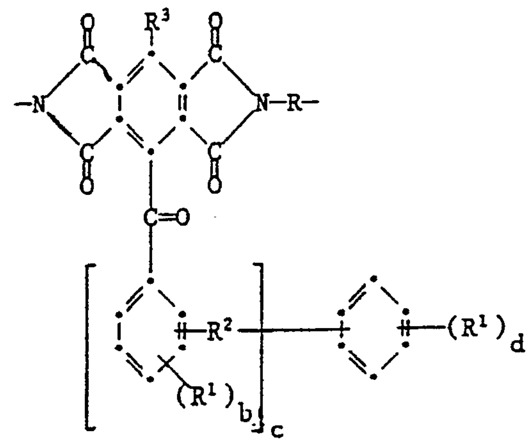

(IIb),

in which $R^1$, $R^2$, $R^3$ a, b, c and d are as defined in claim 1 and R is an aromatic radical which is substituted in the two ortho-positions relative to at least one N atom by alkyl, cycloalkyl, alkoxy, alkoxyalkyl, alkylthio, alkylthioalkyl or aralkyl or in which two adjacent C atoms of the aromatic radical are substituted by alkylene.

**13.** A copolymer which has an average molecular weight of at least 2000 and is selected from the group comprising polyamides, saturated polyesters, polycarbonates, polyamideimides, polyester-imides, polyester-amides, polysiloxanes, unsaturated polyesters, epoxide resins, aromatic polyethers, aromatic polyether-ketones, aromatic polyether sulfones, aromatic polyketones, aromatic polythioethers or mixtures of these polymers, wherein the copolymer contains at least 5 mole%, based on the copolymer, of at least one structural element of the formula I or II according to claim 1 in which q is 1.

**14.** A polyimide according to claim 12, wherein R is a radical according to claim 5.

**15.** A polyimide according to claim 12, which is a compound according to any one of claims 8 to 11.

**16.** The use of the compounds according to claim 12 or 13 for the production of protective films, passivation coatings and as a photographic recording material for thermostable relief images.

## Revendications

**1.** Procédé pour préparer des polymères réticulés, caractérisé en ce qu'on soumet à irradiation par un rayonnement riche en énergie (rayonnement énergétique) un homopolymère ou un copolymère présentant un poids moléculaire moyen d'au moins 2000 et contenant au moins 5 moles %, par rapport au polymère, d'au moins un élément structurel de formules I et/ou II

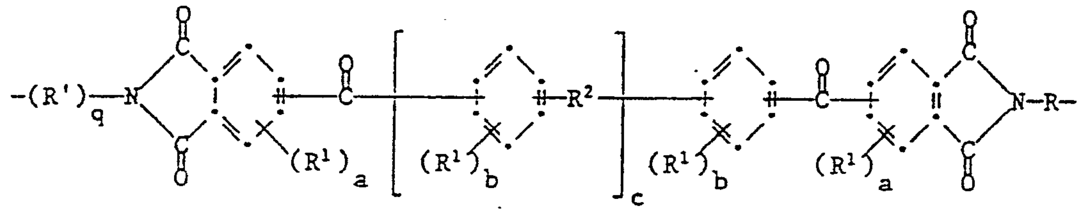

(I)

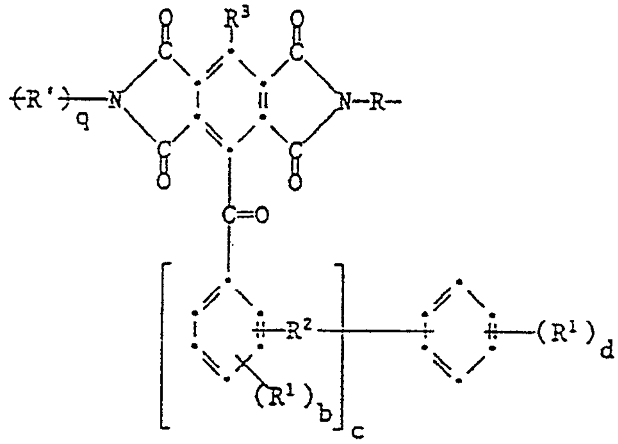

(II),

dans lesquelles

$R^1$ représente un atome d'halogène, un groupe nitro, alkyle en $C_1$ à $C_6$, alcoxy en $C_1$ à C6, alkylthio en $C_1$ à $C_6$ (pouvant être substitué par un groupe phényle), phényle, phénoxy ou phénylthio,

$R^2$ est une liaison directe ou représente un groupe de pontage,

$R^3$ représente un atome d'hydrogène ou un groupe aryle ou a le même sens que $R^1$,

a vaut 0, 1, 2 ou 3 ; b vaut 0, 1, 2, 3 ou 4 ; c et d valent chacun 0, 1, 2, 3, 4 ou 5 ; q vaut 0 ou 1 ; et

si a, b et d valent 2, deux $R^1$ peuvent être fixés en position ortho et former ensemble -C=CH=CH=CH-, et

R et R' représentent chacun un reste aliphatique divalent, non substitué ou substitué (qui peut être interrompu par des hétéro-atomes, par des groupes aromatiques, hétérocycliques ou cycloaliphatiques), un reste cycloaliphatique ou araliphatique substitué ou non substitué, un reste aromatique (dans lequel deux noyaux aryles peuvent être reliés par un groupe aromatique) ou un reste aromatique (substitué par au moins un groupe alkyle, un groupe cycloalkyle, un groupe alcoxy, un groupe alcoxyalkyle, un groupe alkylthio, un groupe alkylthiolalkyle ou un aralkyle) ou ce sont chacun un reste aromatique fixé par un groupe alkylène sur deux atomes de C voisins du reste aromatique, R étant un reste aromatique qui est fixé par substitution sur les deux positions en ortho par rapport à au moins un atome d'azote, lorsque q est nul.

2. Procédé selon la revendication 1 pour produire des images en relief sur un support, ce procédé comprenant l'exposition, du côté image à travers un photomasque , d'une matière de support revêtue du polymère, que l'on soumet à un rayonnement riche en énergie et l'enlèvement, à l'aide d'un révélateur, des parties non exposées, procédé caractérisé en ce qu'on utilise un homopolymère ou un copolymère selon la revendication 1.

3. Procédé selon la revendication 1 pour préparer des couches protectrices sur un support, ce procédé comprenant l'exposition du côté surface d'une matière de support revêtue d'un polymère, que l'on soumet à un rayonnement énergétique, procédé caractérisé en ce qu'on utilise un homopolymère ou un copolymère selon la revendication 1.

4. Procédé selon l'une des revendications 1 à 3, caractérisé en ce que les éléments structurels répondent aux formules Ia ou IIa.

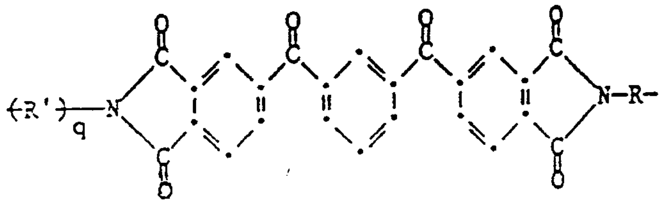

(Ia)

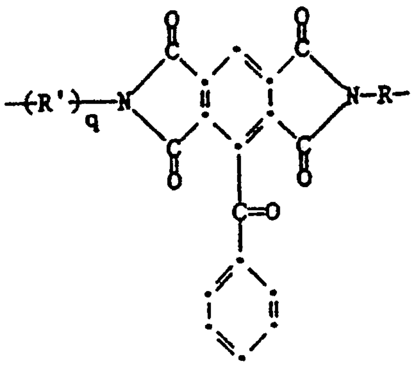

(IIa),

dans lesquelles, q, R et R' ont le sens indiqué à la revendication 1.

5. Procédé selon l'une des revendications 1 à 3, caractérisé en ce que le substituant du reste aromatique R ou R' est un groupe alkyle, alcoxy ou alcoxyalkyle comportant 1 à 6 atomes de carbone, benzyle ou triméthylène ou tétraméthylène.

6. Procédé selon l'une des revendications 1 à 3, caractérisé en ce qu'un ou deux substituants du reste aromatique R ou R' sont fixés en position ortho par rapport à l'atome d'azote.

7. Procédé selon l'une des revendications 1 à 3, caractérisé en ce que R contient, quand il est un reste aliphatique, 2 à 20 atomes de carbone ; comme reste cycloaliphatique,5 à 8 atomes de carbone de noyau ; comme reste araliphatique, 7 à 30 atomes de carbone ; comme reste aromatique comportant des noyaux aryles reliés par l'intermédiaire d'un groupe aliphatique, 13 à 30 atomes de carbone ; et comme reste aromatique substitué, 7 à 30 atomes de carbone.

8. Procédé selon l'une des revendications 1 à 3, caractérisé en ce qu'il s'agit, pour le polymère, d'un homopolyimide ou copolyimide, soluble dans les solvants organiques et comportant 5 à 100 moles % d'éléments structurels répondant aux formules I et/ou II, dans lesquels q est nul, et R représente un reste aromatique qui porte sur les deux positions en ortho d'au moins un atome d'azote, comme substituant, un groupe alkyle, cycloalkyle, alcoxy, alcoxyalkyle, alkylthio, alkylthio alkyle, aralkyle, ou bien deux atomes de C, voisins, du reste aromatique portent comme substituant un groupe alkylène, et le polymère comporte 0 à 95 moles % d'éléments structurels de formule III

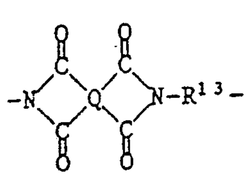

(III)

dans laquelle Q est un reste organique tétravalent et $R^{13}$ représente un reste organique divalent, et $R^{13}$ a le sens de R.

**9.** Procédé selon la revendication 8, caractérisé en ce que Q représente

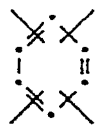 , 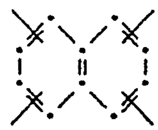 ,

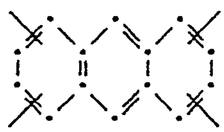 , 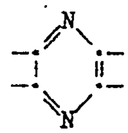 , 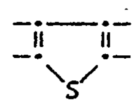

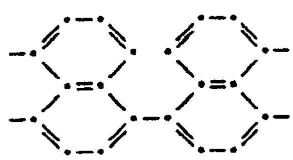 , 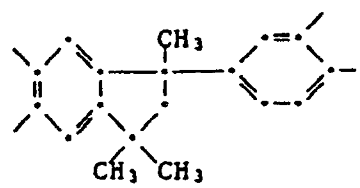

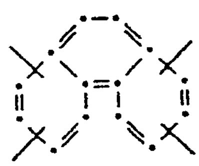 , 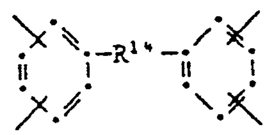

formules dans lesquelles $R^{14}$ est une liaison directe ou représente un groupe de pontage répondant aux formules

$-O-$, $-S-$, $-SO_2-$, 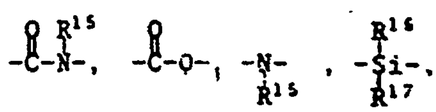

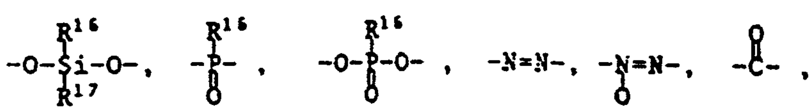

$-NH-$, 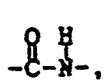 $-CH_2-$, $-CH_2CH_2-$, 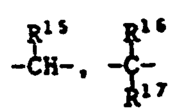

formules dans lesquelles $R^{15}$, $R^{16}$ et $R^{17}$ représentent chacun un groupe alkyle ayant 1 à 6 atomes de carbone, phényle ou benzyle, et $R^{16}$ et $R^{17}$ peuvent également représenter un groupe alcoxy ayant 1 à 6 atomes de carbone, phénoloxy ou benzyloxy.

**10.** Procédé selon la revendication 9, caractérisé en ce que, dans les formules 1 et 2, R représente des restes répondant aux formules

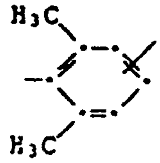, 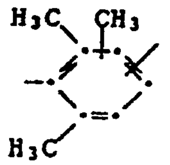, 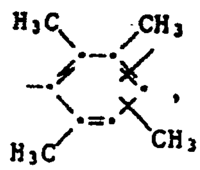, 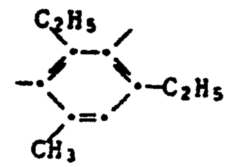

formules dans lesquelles les liaisons libres sont en position méta ou para l'une par rapport à l'autre, ou les R ont pour formule

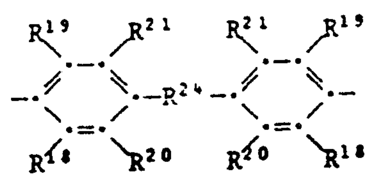

dans laquelle $R^{18}$ et $R^{19}$ représentent chacun, indépendamment l'un de l'autre, un groupe méthyle, éthyle, propyle ou isopropyle, et $R^{20}$ et $R^{21}$ représentent chacun un atome d'hydrogène, ou ont le sens de $R^{19}$ ou bien $R^{18}$ et $R^{20}$ forment ensemble un groupe triméthylène ou tétraméthylène, et $R^{19}$ et $R^{21}$ représentent chacun un atome d'hydrogène, et $R^{24}$ est une liaison directe ou représente un groupe $CH_2$, propylidène-2,2 ou CO.

**11.** Procédé selon la revendication 9, caractérisé en ce qu'on utilise des polyimides comportant des éléments structurels récurrents répondant aux formules

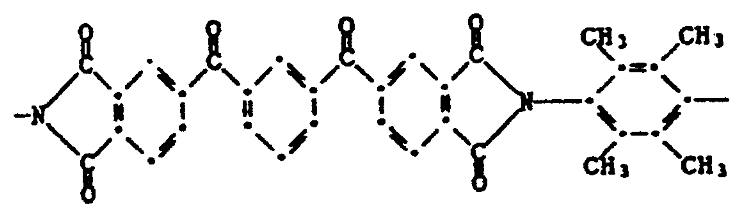

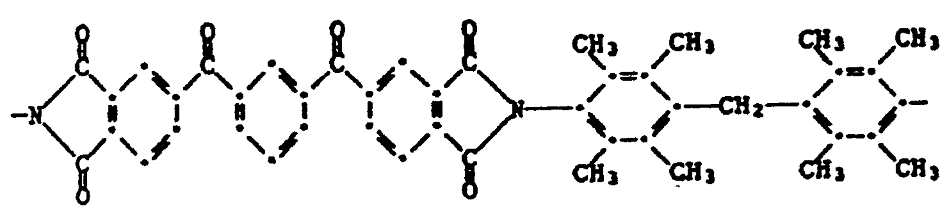

ou comportant des mélanges de ces éléments structurels.

**12.** Homopolyimide ou copolyimide ayant un poids moléculaire moyen d'au moins 2000, qui contient au moins 5 moles %, par rapport au polyimide, d'au moins un élément structurel répondant aux formules Ib ou IIb

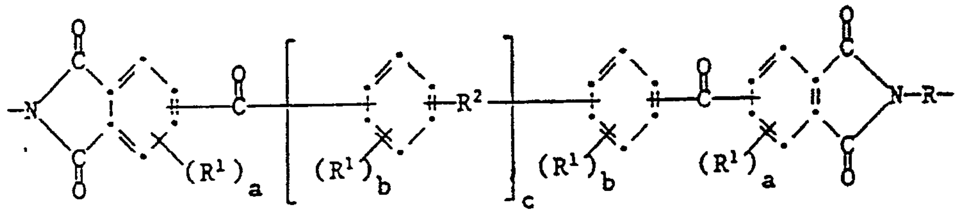

(Ib),

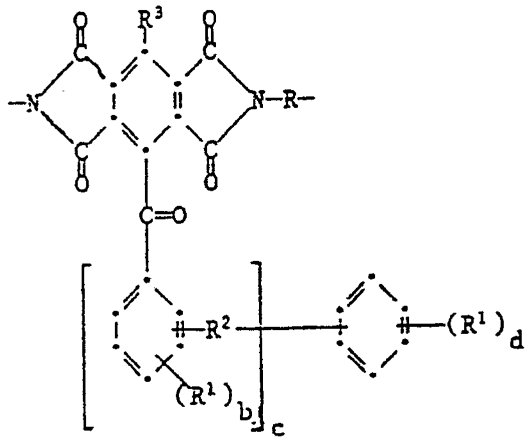

(IIb),

dans lesquelles $R^1$ , $R^2$, $R^3$, a, b, c et d ont le sens défini à la revendication 1, et R représente un reste aromatique, qui est substitué, sur les deux positions en ortho par rapport à au moins un atome d'azote, par un groupe alkyle, cycloalkyle, alcoxy, alcoxyalkyle, alkylthio, alkylthioalkyle ou aralkyle, ou bien deux atomes de C voisins faisant partie du reste aromatique portent un groupe alkylène comme substituant.

**13.** Copolymére ayant un poids moléculaire moyen d'au moins 2000, qui est choisi dans l'ensemble constitué par les polyamides, les polyesters saturés, les polycarbonates, les polyamides imides, les polyester imides, les polyester amides, les polysiloxanes, les polyesters insaturés, les résines époxydes, les polyéthers aromatiques, les polyéther cétones aromatiques, les polyéther sulfones aromatiques, les polycétones aromatiques, les polythioéthers aromatiques ou des mélanges de ces polymères, copolymére caractérisé en ce qu'il contient au moins 5 moles %, par rapport au copolymère, d'au moins un élément structurel répondant aux formules I ou II selon la revendication 1, dans lesquelles q vaut 1.

**14.** Polyimide selon la revendication 12, caractérisée en ce que R est un reste selon la revendication 5.

**15.** Polyimide selon la revendication 12, caractérisé en ce qu'il s'agit d'un composé selon l'une des revendications 8 à 11.

**16.** Utilisation des composés selon les revendications 12 ou 13 pour préparer des pellicules protectrices, des laques et vernis de passivation ou à titre de matières pour enregistrement photographique pour l'obtention d'images thermostables en relief.